# FASCICULE DE BREVET EUROPEEN

(11) **EP 2 302 636 B1**
(45) Date de publication et mention de la délivrance du brevet: **05.11.2014**
(21) Numéro de dépôt: 10009602.3
(22) Date de dépôt: 15.09.2010
(51) Int. Cl.: G11C 16/10, G06F 12/02

(54) **Procédé de lecture d'une mémoire non volatile au moyen de métadonnées et d'une table de correspondance**
Verfahren zum Auslesen eines nichtflüchtigen Speichers mit Hilfe von Metadaten und eine Entsprechungstabelle
Method for reading a non volatile memory using metadata and a correspondence table

(30) Priorité: 21.09.2009 FR 0904499; 21.09.2009 FR 0904498; 21.09.2009 FR 0904500; 21.09.2009 FR 0904501
(43) Date de publication de la demande: 30.03.2011
(73) Titulaire: STMicroelectronics (Rousset) SAS, 13790 Rousset (FR)
(72) Inventeur: Rousseau, Hubert, 13012 Marseille (FR)
(74) Mandataire: Marchand, André

(56) Documents cités:
- WO-A2-2007/081598
- WO-A2-2009/067476
- US-A1- 2007 124 531
- US-A1- 2009 198 902

## Description

La présente invention concerne les mémoires non volatiles et notamment les mémoires effaçables et programmables électriquement de type FLASH.

Le marché des mémoires effaçables et programmables électriquement sur microplaquettes de semi-conducteur est traditionnellement partagé entre la famille des mémoires EEPROM et celle des mémoires FLASH (ou FLASH-EEPROM).

Les mémoires EEPROM comprennent des cellules mémoire comportant un transistor à grille flottante et un transistor d'accès. Les mémoires de type FLASH ne comportent qu'un transistor à grille flottante par cellule mémoire, et présentent l'avantage d'une grande compacité en termes de surface de semi-conducteur occupée (nombre de cellules mémoire par unité de surface). En contrepartie, l'absence de transistor d'accès nécessite de prévoir des tensions de seuil positives tant pour les cellules mémoire effacées que les cellules mémoire programmées, afin de ne pas créer des courts-circuits sur les lignes de bit. Les oxydes de grille doivent ainsi être épais pour maintenir durablement les charges électriques piégées dans les grilles flottantes, ce qui entraîne une augmentation du temps d'effacement. L'effacement des cellules mémoire FLASH est souvent effectué par effet tunnel tandis que leur programmation est effectuée par injection d'électrons chauds. Le temps nécessaire à la programmation des cellules mémoire est court, par exemple 5 microsecondes, tandis que le temps d'effacement est long, par exemple 100 millisecondes. Par ailleurs, la programmation par injection d'électrons chauds entraîne l'apparition d'un fort courant de programmation, de sorte que le nombre de cellules mémoire pouvant être programmées simultanément est généralement limité à un octet.

Les mémoires FLASH ont ainsi été, originellement, dédiées au stockage de masse. Divers perfectionnements furent ensuite proposés afin qu'elles puissent offrir des caractéristiques se rapprochant des mémoires EEPROM. Parmi les perfectionnements on peut citer la conception d'une mémoire FLASH effaçable par page, telle que décrite par le brevet EP 1 342 244 au nom de la demanderesse.

Ces perfectionnements ont permis de commercialiser des mémoires FLASH effaçables par page offrant les mêmes fonctionnalités apparentes que certaines mémoires EEPROM, mais dans lesquelles des limitations subsistaient :
- un temps d'effacement long, ce qui peut s'avérer gênant dans certaines applications. En effet, le temps apparent d'écriture d'un octet est essentiellement imposé par le temps d'effacement de la page qui reçoit l'octet, laquelle doit être entièrement effacée chaque fois qu'un nouvel octet y est programmé, les autres octets initialement présents dans la page devant également y être écrits ;
- une absence de protection contre les coupures intempestives de tension d'alimentation pendant l'effacement d'une page ou la programmation de blocs.

De ce fait les mémoires FLASH ne pouvaient pas, initialement, être utilisées comme mémoires enchâssées ("Embedded memories") dans des circuits intégrés destinés à des applications où le risque de coupure d'alimentation électrique est élevé. Il s'agit généralement d'applications aux cartes à puce ou aux étiquettes électroniques, dans lesquelles l'alimentation des circuits intégrés peut disparaître en cas "d'arrachement" (retrait de la carte du lecteur de carte).

D'autres perfectionnements aux mémoires de type FLASH ont donc visé l'optimisation du temps d'écriture des données et la protection des données contre l'arrachement. A cet effet, on a proposé des procédés d'écriture de données dits "à effacement différé". Selon ces procédés, l'écriture de données ne s'effectue que dans des pages effacées et consiste dans des cycles de programmation de cellules mémoire sans cycle d'effacement associé. La programmation successive de données dans des pages effacées fait apparaître des données invalides, d'où un remplissage d'espace mémoire supérieur à l'espace mémoire nécessaire pour stocker les données valides. Lorsque l'espace mémoire se réduit, les données invalides sont effacées pour libérer de l'espace mémoire (effacement différé). On a généralement proposé d'utiliser les procédés d'écriture à effacement différé en relation avec la protection des données contre l'arrachement ("tearing proof programming" ou "anti-tearing methods"), car les applications nécessitant une écriture rapide de données sont généralement des applications sensibles aux problèmes d'alimentation électrique (cartes à puce).

A titre d'exemple, la demande de brevet US2005/0251643 décrit un procédé d'écriture de données protégé contre l'arrachement ("tearing proof programming", Cf. paragraphe 0008) adapté aux mémoires FLASH. Les pages de la mémoire sont utilisées pour mémoriser, en sus des données utiles, une adresse logique de page et une valeur de comptage. Une table de correspondance ("Look-Up Table") permet d'associer une adresse logique à une adresse physique (adresse électrique). Lorsqu'une donnée doit être écrite dans une page, le contenu de la page est copié dans un tampon de page. La nouvelle donnée y est incorporée, tandis que la valeur de comptage est incrémentée. Le contenu de la page mis à jour est ensuite programmé dans une autre page, avec la même adresse logique. La page initiale est ensuite effacée.

La demande de brevet EP 1 988 550 au nom de la demanderesse décrit un procédé d'écriture de données à effacement différé, dans lequel l'effacement de pages est effectué en "N" étapes d'effacement partiel de courte durée, qui sont appliquées à des pages autres que celles utilisées pour écrire des données. Une étape d'effacement partiel est déclenchée après chaque étape de programmation de données, de sorte qu'après N étapes de programmation, on obtient des pages effacées. On effectue ensuite une "rotation" entre des pages effacées et des pages contenant des données invalides, les pages effacées étant utilisées pour écrire de nouvelles données tandis que les pages invalides sont soumises au processus d'effacement progressif. A cet effet, une zone mémoire auxiliaire comprend un secteur dit "courant" comprenant des pages auxiliaires effacées utilisables pour écrire des données, un secteur dit "de sauvegarde" comprenant des pages auxiliaires contenant des données rattachées à des pages à effacer ou en cours d'effacement, un secteur dit "de transfert" comprenant des pages contenant des données à transférer dans des pages effacées, et un secteur dit "indisponible" comprenant des pages en cours d'effacement.

En résumé, les procédés antérieurs à effacement différé manipulent des pages entières. Comme les pages de données sont écrites dans des pages matérielles pré-effacées dont l'adresse est arbitraire, on doit associer à chaque page de données une adresse logique de page ou "étiquette" qui permet de trouver la page. Cette "étiquette" est enregistrée avec les données de la page et est "attachée" à celles-ci, c'est-à-dire concaténée et placée dans la même page physique. Une autre caractéristique des procédés antérieurs est que chaque programmation d'une donnée en réponse à une commande d'écriture nécessite la lecture de toutes les données de la page, l'insertion de la nouvelle donnée dans les données de la page, puis la reprogrammation de toutes les données de la page mise à jour. Il s'ensuit une "consommation" importante de pages effacées, en d'autres termes un "cyclage" élevé et par conséquent une accélération de l'usure des cellules mémoire (le "cyclage" représentant le nombre de fois qu'une page a été effacée).

Le préambule de la revendication indépendante 1 est basé sur le document WO 2007081598 (voir les paragraphes [0071] et [0072]).

La présente invention propose des perfectionnements aux procédés d'écriture à effacement différé.

Plus particulièrement, des modes de réalisation de l'invention concernent un procédé pour écrire et lire des données dans des cellules mémoire non volatiles effaçables et programmables électriquement, **caractérisé en ce qu**'il comprend les étapes consistant à prévoir une première zone mémoire non volatile ; programmer dans des blocs effacés de la première zone mémoire des données ayant chacune une adresse logique définie en relation avec une mémoire virtuelle ; prévoir une seconde zone mémoire non volatile ; programmer dans la seconde zone mémoire des structures de métadonnées associées aux données présentes dans la première zone mémoire, et comprenant, pour chaque donnée : l'adresse de la donnée dans la première zone mémoire, l'adresse logique de la donnée, et une information sur le statut, valide ou invalide, de la donnée ; configurer, dans une zone mémoire volatile, une table de correspondance comprenant, pour chaque adresse logique d'une donnée enregistrée dans la première zone mémoire, des adresses de structures de métadonnées comprenant cette adresse logique ; et lire la table de correspondance, puis lire des structures de métadonnées que la table de correspondance désigne pour retrouver, à partir de l'adresse logique d'une donnée, l'adresse dans la première zone mémoire d'un bloc contenant une donnée valide ayant cette adresse logique.

Selon un mode de réalisation, le procédé comprend, en réponse à une commande de lecture d'une donnée mentionnant l'adresse logique de la donnée, les étapes consistant à rechercher dans la table de correspondance des adresses de structures de métadonnées dans lesquelles figure cette adresse logique, lire ces structures de métadonnées, et rechercher des structures de métadonnées associées à une donnée valide, lire dans des structures de métadonnées associées à la donnée valide, l'adresse de la donnée valide dans la première zone mémoire, et lire la donnée valide dans la première zone mémoire.

Selon un mode de réalisation, le procédé comprend une étape de construction de la table de correspondance de manière à ce que celle-ci comprenne : une première zone indexée sur des adresses logiques, dans laquelle à une adresse logique est associée une adresse d'une première structure de métadonnées contenant cette adresse logique, et une seconde zone non indexée comprenant des adresses de secondes structures de métadonnées comprenant des adresses logiques.

Selon un mode de réalisation, les adresses logiques d'indexation de la première zone de la table de correspondance sont des adresses de pages logiques de la mémoire virtuelle contenant plusieurs données.

Selon un mode de réalisation, l'adresse d'une donnée dans la première zone mémoire est enregistrée dans les structures de métadonnées sous la forme d'un premier index indiquant la position d'une page dans la première zone mémoire et d'un second index indiquant la position d'un bloc dans la page, l'adresse logique d'une donnée est enregistrée dans les structures de métadonnées sous la forme d'un premier index indiquant la position d'une page logique dans la mémoire virtuelle et d'un second index indiquant la position d'un bloc logique dans la page logique, et une adresse de structure de métadonnées est enregistrée dans la table de correspondance sous la forme d'un index indiquant la position d'une page de métadonnées dans la seconde zone mémoire et d'un index indiquant l'emplacement de la structure de métadonnées dans la page de métadonnées.

Selon un mode de réalisation, le procédé comprend, en réponse à une commande de lecture d'une donnée incluant une adresse logique, les étapes consistant à : au moyen de l'adresse logique, rechercher dans la première zone de la table de correspondance une adresse d'une première structure de métadonnées dans laquelle figure cette adresse logique, lire la première structure de métadonnées, si la première structure de métadonnées se rapporte à une donnée valide, lire dans la structure de métadonnées l'adresse de la donnée valide dans la première zone mémoire, et lire la donnée dans la première zone mémoire, si la première structure de métadonnées se rapporte à une donnée invalide, lire dans la seconde zone de la table de correspondance des adresses de secondes structures de métadonnées et lire les secondes structures de métadonnées jusqu'à trouver une structure de métadonnées comprenant cette adresse logique et associée à une donnée valide, puis lire dans cette structure de métadonnées l'adresse de la donnée valide dans la première zone mémoire, et lire la donnée dans la première zone mémoire.

Selon un mode de réalisation, le procédé comprend une étape consistant à configurer la table de correspondance de manière à ce que la seconde zone comprenne des adresses de structures de métadonnées classées selon un ordre croissant ou décroissant d'adresses logiques contenues dans les structures de métadonnées que ces adresses désignent, et dans lequel l'étape de lecture de la seconde zone de la table de correspondance est conduite en appliquant une méthode convergente par approches successives basée sur le classement des adresses des structures de métadonnées, jusqu'à trouver l'adresse d'une structure de métadonnées comportant l'adresse logique, si une telle structure de métadonnées existe dans la seconde zone mémoire.

Selon un mode de réalisation, le procédé comprend une étape consistant à, après programmation d'une donnée dans la première zone mémoire, mettre à jour une structure de métadonnées de manière à ce que l'adresse logique de la donnée venant d'être écrite figure dans la structure de métadonnées mise à jour, puis mettre à jour la table de correspondance de manière à ce que l'adresse de la structure de métadonnées mise à jour figure dans la table de correspondance.

Selon un mode de réalisation, le procédé comprend une étape consistant à configurer les structures de métadonnées de la seconde zone mémoire sous forme de descripteurs de pages, chaque descripteur étant associé à une page de la première zone mémoire.

Selon un mode de réalisation, le procédé comprend une étape consistant à prévoir dans un descripteur : un premier champ contenant l'adresse de la page dans la première zone mémoire ou un index de la page, un second champ contenant une adresse de page logique ou un index de page logique, et pour chaque bloc de la page de la première zone mémoire à laquelle le descripteur est associé, un troisième champ contenant une information sur l'emplacement du bloc dans la page, une information sur le statut du bloc parmi au moins les trois statuts suivants : bloc effacé, bloc contenant une donnée valide ou bloc contenant un donnée invalide, et une information sur la position dans la page logique de la donnée enregistrée dans le bloc considéré.

Selon un mode de réalisation, le troisième champ est un champ indexé dont la position dans le descripteur désigne un bloc de la page de la première zone mémoire à laquelle le descripteur est associé, et dont le contenu peut présenter une valeur effacée indiquant que le bloc désigné est effacé, une valeur programmée indiquant que le bloc désigné contient une donnée invalide, ou une valeur partiellement programmée donnant une information sur l'emplacement dans la page logique de la donnée enregistrée dans le bloc.

Selon un mode de réalisation, le procédé comprend une étape consistant à programmer dans chaque descripteur un compteur d'usure de la page à laquelle le descripteur est associé, et une étape consistant à incrémenter le compteur d'usure après chaque effacement de la page.

Selon un mode de réalisation, le procédé comprend une étape consistant à prévoir dans la table de correspondance une troisième zone comprenant des adresses de descripteurs associés à des pages effacées de la première zone mémoire.

Selon un mode de réalisation, le procédé comprend une étape consistant à classer les adresses de descripteurs dans la troisième zone de la table de correspondance par ordre croissant ou décroissant des valeurs des compteurs d'usure contenus dans les descripteurs que ces adresses désignent.

Selon un mode de réalisation, le procédé comprend une étape consistant à prévoir dans la table de correspondance une zone comprenant des adresses de descripteurs associés à des pages ne contenant que des données invalides.

Selon un mode de réalisation, le procédé comprend une étape consistant à effacer des pages de la première zone mémoire ne contenant que des données invalides et effacer des pages de la seconde zone mémoire ne contenant que des structures de métadonnées invalides.

Selon un mode de réalisation, le procédé comprend une étape consistant à agencer les première et seconde zones mémoire au sein d'une même mémoire non volatile.

Des modes de réalisation concernent également un circuit intégré comprenant une unité de traitement, au moins une mémoire non volatile comprenant des cellules mémoire effaçables et programmables électriquement, **caractérisé en ce que** l'unité de traitement est configurée pour recevoir des commande d'écriture et de lecture et exécuter les commandes conformément au procédé décrit ci-dessus.

Des modes de réalisation de l'invention concernent également un objet portatif comprenant un tel circuit intégré.

Des modes de réalisation d'un procédé d'écriture et de lecture de données mettant en oeuvre un ou plusieurs aspects de l'invention seront décrits dans ce qui suit en se référant à titre non limitatif aux dessins annexés parmi lesquels :
- la figure 1 représente un dispositif équipé d'une mémoire non volatile et comprenant des moyens d'exécution d'un mode de réalisation du procédé,
- la figure 2 représente schématiquement un agencement de données et de métadonnées dans la mémoire du circuit intégré,
- la figure 3 est un organigramme simplifié décrivant une opération de programmation de données dans la mémoire du circuit intégré,
- les figures 4A à 4E sont des organigrammes simplifiés décrivant des exemples d'étapes de programmation de données dans la mémoire du circuit intégré,
- les figures 5A à 5E illustrent les étapes de programmation de données décrites par les figures 4A à 4E,
- la figure 6 représente une structure de métadonnées d'un premier type,
- la figure 7 représente une structure de métadonnées d'un second type,
- la figure 8 illustre schématiquement une configuration d'une table de correspondance,
- la figure 9 est une représentation schématique de diverses tâches susceptibles d'être exécutées par le circuit intégré,
- la figure 10 est un organigramme décrivant des tâches d'initialisation conduites par le circuit intégré à sa mise sous tension,
- les figures 11 et 12 sont des organigrammes décrivant respectivement l'exécution d'une commande d'écriture et d'une commande de lecture de données dans la mémoire du circuit intégré, et
- les figures 13 à 16 sont des organigrammes décrivant des tâches de maintenance de la mémoire exécutées par le circuit intégré.

L'invention concerne divers perfectionnements aux procédés d'écriture de données à effacement différé, applicables notamment aux mémoires FLASH. L'invention présente plusieurs aspects, qui seront décrits dans des paragraphes distincts dans la description qui suit. Il sera noté que l'invention ne se limite pas à une combinaison de ces aspects. Elle concerne chaque aspect considéré en lui-même indépendamment des autres aspects. Ainsi, dans ce qui suit, des termes tels que "selon l'invention" ou "selon un aspect de l'invention" peuvent se rapporter à des modes de réalisation de l'invention qui n'implémentent qu'un seul de ces aspects ou une partie de ces aspects, ou tous ces aspects en même temps, et ne signifient pas que tous les modes de réalisation de l'invention comportent la caractéristique évoquée.

II sera considéré dans ce qui suit, par convention, que le "1" logique représente la valeur d'une donnée présente dans une cellule mémoire effacée, ou "valeur logique d'effacement". Par conséquent le "0" logique représente la valeur d'une donnée présente dans une cellule mémoire programmé, ou "valeur logique de programmation". D'autre part, les données sont représentées sur diverses figures en notation hexadécimale, la valeur d'un octet effacé étant ainsi "FF" selon cette notation.

### I - Exemple de dispositif mettant en oeuvre le procédé

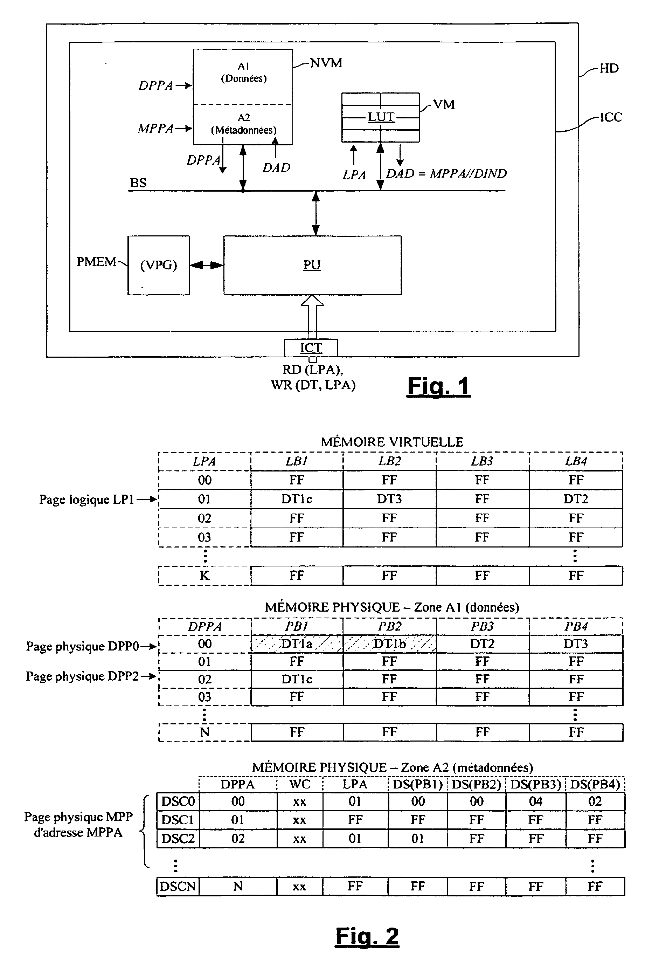

La figure 1 représente un exemple de dispositif comprenant des moyens d'exécution du procédé d'écriture et de lecture de données selon l'invention. Le dispositif prend la forme d'un circuit intégré ICC sur microplaquette de semi-conducteur comprenant une mémoire non volatile NVM, une mémoire volatile VM, une unité de traitement PU et une interface de communication ICT. Les mémoires NVM et VM sont reliées à l'unité de traitement PU par l'intermédiaire d'un bus BS de données et d'adresse, et d'un bus de contrôle (non représenté). La mémoire NVM est une mémoire programmable par octet et effaçable par page, par exemple une mémoire FLASH comprenant des pages de 256 octets.

L'unité de traitement PU, par exemple un microprocesseur ou un microcontrôleur, est équipée d'une mémoire programme PMEM dans laquelle est enregistré un programme VPG de "virtualisation" de la mémoire NVM, configuré pour exécuter le procédé de l'invention. Alternativement, l'unité de traitement PU pourrait être un séquenceur à logique câblée (machine d'état ou séquenceur microprogrammé) configuré pour exécuter le procédé de l'invention sans intervention d'un programme stocké dans une mémoire programme. Ainsi des expressions telles que "le programme exécute", "le programme est configuré pour", "le programme gère", "le programme assure" qui pourront être utilisées dans ce qui suit ne signifient pas que le procédé selon l'invention est exclusivement mis en oeuvre sous forme de programme exécuté par un microprocesseur.

Dans l'exemple de réalisation représenté sur la figure 1, le circuit intégré ICC est monté sur ou enchâssé dans un support portable HD ("Handheld Device"), par exemple une carte en matière plastique. Le circuit ICC comprend des moyens d'interface de communication ICT de type à contact ou sans contact, par exemple des contacts ISO 7816 ou une interface de communication par couplage inductif ISO 14443 ou ISO 15693. Le circuit intégré reçoit, par l'intermédiaire des moyens d'interface ICT, des commandes WR(LBA, DT) d'écriture de données dans la mémoire NVM et des commandes RD(LBA) de lecture de données dans la mémoire NVM. Chaque commande comprend un code de la commande et une adresse logique LBA de la donnée à lire ou a écrire. Une commande d'écriture comporte en outre une donnée DT à écrire dans la mémoire.

Le programme de virtualisation VPG gère le contenu de la mémoire NVM et assure l'exécution des commandes d'écriture et de lecture de manière à ce que, vue de l'extérieur, la mémoire NVM soit perçue comme une mémoire virtuelle programmable par bloc, dans laquelle un bloc de données peut être indéfiniment programmé sans se soucier de son effacement. Les adresses logiques LBA fournies avec les commandes forment donc des adresses désignant des blocs de la mémoire virtuelle. De telles adresses sont appelées "adresses logiques" et les blocs qu'elles désignent des "blocs logiques".

A l'intérieur de la mémoire NVM, le programme VPG assure l'écriture des données selon un procédé d'écriture à effacement différé. A titre d'exemple, une étape d'écriture avec effacement différé de l'octet suivant :
"01010101"
consiste à écrire cette donnée dans un octet effacé dont tous les bits sont à 1 :
11111111,
et nécessite seulement la programmation des premier, troisième, cinquième et septième bits de l'octet afin de les mettre à 0.

Ainsi, en réponse à une commande d'écriture de données, le programme VPG doit seulement programmer les données dans des cellules mémoires effacées, et plus précisément ne programmer que les cellules mémoire devant contenir un bit égal à 0. Cette "écriture" réduite à une programmation de cellules mémoire est faite sans effacement de précédentes données ayant la même adresse logique, qui peuvent éventuellement avoir déjà été programmées dans la mémoire physique. Ces données précédentes sont invalidées par le programme VPG mais ne sont pas effacées.

Le programme VPG assure l'effacement ultérieur des données invalides lors de l'exécution de tâches de maintenance de la mémoire, pour obtenir de nouvelles cellules mémoire effacées prêtes à recevoir des données.

En sus des tâches d'effacement de données invalides, le programme VPG peut conduire des tâches de maintenance consistant à regrouper des données valides qui sont dispersées dans le plan mémoire, afin de faire apparaître des groupes de données invalides qui seront ensuite effacés pour libérer de l'espace mémoire.

On décrira maintenant plus en détail divers aspects du procédé de lecture et d'écriture selon l'invention, mis en oeuvre au moyen du programme VPG.

### II - Premier aspect de l'invention : prévision d'une zone de métadonnées

Dans l'art antérieur, la programmation de blocs de données dans des pages préalablement effacées implique que chaque donnée soit écrite dans un bloc dont l'adresse physique est différente de l'adresse logique. La donnée de type "bloc" doit être "étiquetée" d'une manière similaire à l'étiquetage des pages dans les procédés décrits par EP 1 988 550 ou US2005/0251643. L'étiquette est par exemple l'adresse logique de la donnée et est concaténée avec la donnée. Une telle méthode d'étiquetage appliquée à des blocs de données plutôt qu'à des pages de données entraîne une multiplication rédhibitoire du nombre d'étiquettes et une complexification des étiquettes (l'adresse d'un bloc étant plus longue de l'adresse d'une page). Se pose alors un problème d'encombrement de l'espace mémoire par des données d'étiquetage.

L'invention propose une solution avantageuse permettant d'identifier des données dans un espace mémoire sans avoir recours à la technique d'étiquetage classique, en prévoyant des données de gestion agencées dans un espace mémoire dédié, et permettant de gérer la mémoire en référence à une structure de mémoire virtuelle.

La figure 2 représente schématiquement une telle structure de la mémoire virtuelle, c'est-à-dire la mémoire telle que perçue de l'extérieur grâce au programme VPG. La figure 2 représente également l'organisation de l'espace mémoire physique à l'intérieur de la mémoire NVM.

La mémoire virtuelle comporte K+1 pages logiques LP (LP0, LP1...LPK) désignées par les adresses logiques LPA (00, 01...K). Les pages logiques LP sont ici de même taille que les pages matérielles de la zone mémoire A1 de la mémoire NVM, soit ici 256 octets, et sont divisées en blocs logiques LB adressables individuellement et désignés par les adresses LBA présentes dans les commande WR et RD. L'adresse LBA d'un bloc logique est formée par l'adresse LPA de la page logique dans laquelle se trouve le bloc et par l'index du bloc dans la page, c'est-à-dire son rang dans la page.

Dans un mode de réalisation, le nombre de bloc par page logique est un paramètre d'initialisation du programme VPG dont le choix est laissé à la discrétion de l'utilisateur. On supposera dans ce qui suit et dans l'ensemble de la description, à titre d'exemple non limitatif, que les pages logiques sont divisées en quatre blocs logiques LB (LB1, LB2, LB3, LB4) de 64 octets chacun.

Selon l'invention, l'espace mémoire physique est divisé en une zone mémoire A1 prévue pour stocker des données d'application reçues par l'intermédiaire des commandes d'écriture WR, et une zone mémoire A2 prévue pour recevoir les données de gestion précitées, prévues pour gérer les données présentes dans la première zone mémoire. De telles données de gestion seront appelées "métadonnées" afin de les distinguer des données d'application. Il s'agit donc de données concernant les données d'application.

La zone mémoire A1 comporte N+1 pages physiques de données DPP (DPP0, DPP1,... DPPN) désignées par des adresses physiques DPPA (00, 01,... N). Les pages physiques sont de préférence de même taille que les pages logiques et sont donc ici également de même taille que les pages matérielles de la mémoire. Elles comprennent chacune le même nombre de blocs physiques qu'une page logique, soit quatre blocs physiques PB (PB1, PB2, PB3, PB4) de 64 octets chacun.

La notion de "bloc physique" selon l'invention représente, pour le programme de virtualisation VPG, la plus petite partie de la mémoire physique pouvant être programmée en réponse à une commande d'écriture d'un bloc logique, et est indépendante de l'architecture matérielle de la mémoire NVM, ici une mémoire programmable par octet, pour laquelle plus petite donnée programmable est donc l'octet. Par ailleurs, une "page physique" représente ici, pour le programme de virtualisation VPG, la plus petite partie effaçable du plan mémoire physique, à savoir la page matérielle de la mémoire NVM.

Au niveau de l'interface physique avec la mémoire, la programmation d'un bloc physique de 64 octets peut se traduire par l'application à la mémoire de 64 instructions de programmation d'un octet. La partie d'interface de bas niveau du programme VPG ne sera pas décrite ici en détail. Le programme VPG peut par exemple faire appel à un sous-programme "programmation d'un bloc" comprenant 64 itérations d'une boucle de programmation d'un octet. Lors de la programmation du bloc, la donnée à programmer est placée dans un tampon et le sous-programme est appelé par le programme VPG. De même, le programme VPG peut faire appel à un sous-programme "lecture d'un bloc" comprenant 64 itérations d'une boucle de lecture d'un octet. Alternativement, l'unité de traitement PU est configurée pour lire la mémoire NVM par mots de 32 ou 64 bits.

Toujours en référence à la figure 2, la zone mémoire A2 comporte des pages physiques de métadonnées MPP désignées par leur adresse physique MPPA. Contrairement à la zone mémoire A1, le programme VPG gère la zone mémoire A2 sans notion de "bloc", et programme les métadonnées en exploitant la granularité naturelle qu'offre la mémoire, ici une granularité d'un octet en programmation et en lecture, et une granularité d'une page en effacement.

En revanche, le programme VPG met en oeuvre la méthode d'écriture de données avec effacement différé tant dans la zone mémoire A1 que dans la zone mémoire A2. Ainsi, des tâches de maintenance sont également prévues dans la zone mémoire A2 afin de libérer de l'espace mémoire pour les métadonnées, par effacement de pages contenant des métadonnées invalides.

Les zones mémoire A1, A2 étant dans cet exemple de réalisation deux secteurs de la mémoire NVM, les limites hautes et basses des zones mémoire A1, A2 peuvent être définies par le programme VPG, en fonction de paramètres tels que la taille de la mémoire physique et la taille des blocs logiques au sein des pages de la mémoire virtuelle. Le programme VPG détermine une répartition optimale entre l'espace mémoire attribué aux données et l'espace mémoire attribué aux métadonnées, et détermine ainsi les limites de chaque zone mémoire. La zone mémoire physique A1 est nécessairement plus grande que la zone mémoire virtuelle en raison des données invalides que le processus d'écriture à effacement différé génère. Par exemple, si la mémoire NVM comporte 1024 pages, et si la taille des blocs logiques est de 64 octets, soit 4 blocs par page logique, le programme peut être amené à attribuer 896 pages à la zone A1, soit 224 Ko de données, 128 pages à la zone A2, soit 32 Ko de métadonnées, et à définir une mémoire virtuelle de 218 Ko représentant 85,2% de l'espace mémoire offert par la mémoire physique.

Dans d'autres modes de réalisation, la zone mémoire A2 peut être logée dans une mémoire non volatile dédiée, distincte de la mémoire NVM. Dans ce cas, la zone mémoire A2 peut comporter des pages physiques ayant une taille différente des pages physiques de la mémoire NVM. De façon générale, le procédé selon l'invention n'impose pas de relation structurelle entre les pages physiques de métadonnées et les pages physique de données et nécessite seulement que les métadonnées soient accessibles en lecture et en écriture avec une granularité suffisante pour ne pas ralentir l'exécution du programme.

### Exemple de structure de métadonnées

Selon l'invention, la correspondance entre les adresses physiques des blocs physiques PB de données et les adresses logiques des blocs logiques, est assurée au moyen d'une structure de métadonnées qui est configurée dans la zone mémoire A2 par le programme VPG. Dans un mode de réalisation, cette structure de métadonnées comprend des éléments compacts associés aux pages physiques de la zone mémoire A1, appelés "descripteurs" DSC0, DSC,...DSCN. Les descripteurs assurent le lien entre les pages logiques et les pages physiques ainsi que le lien entre les blocs physiques et les blocs logiques. Ils comprennent également une information sur le statut, valide ou invalide, des données présentes dans les blocs physiques.

Chaque descripteur comporte par exemple les champs suivants :
- un champ d'adresse physique DPPA,
- un champ "WC",
- un champ d'adresse logique LPA, et
- un champ DS ("Data Status") pour chaque bloc physique PB1, PB2, PB3, PB4 de la page physique à laquelle le descripteur est associé, soit ici quatre champs DS au total : DS(PB1), DS(PB2), DS(PB3), DS(PB4).

Le champ d'adresse physique DPPA reçoit l'adresse DPPA de la page physique à laquelle le descripteur est associé, de préférence sous forme d'index indiquant la position de la page physique dans la zone mémoire A1 relativement à la première adresse de la zone mémoire A1. De même, le champ d'adresse logique LPA reçoit l'adresse logique LPA d'une page de la mémoire virtuelle, de préférence sous forme d'index indiquant la position de la page logique dans la mémoire virtuelle.

Le champ WC est réservé à un usage décrit plus loin mais est également utilisé pour invalider un descripteur. La valeur d'invalidation du descripteur est obtenue par programmation de tous les bits du champ WC, soit "000000" en notation hexadécimale.

Les champs DS sont des champs indexés décrivant le statut des données dans les blocs de la page physique à laquelle le descripteur est associé. Plus particulièrement le rang de chaque champ DS dans le descripteur correspond au rang, dans la page physique à laquelle le descripteur est associé, du bloc physique auquel le champ DS est associé. Ainsi, le champ DS(PB1) figure en première position dans le descripteur et est associé au premier bloc PB1 de la page physique à laquelle le descripteur est associé. Le champ DS(PB2) figure en seconde position dans le descripteur et est associé au second bloc PB2 de cette page physique, etc., le nombre de champs DS dans un descripteur étant fonction du nombre de blocs par page physique.

Le contenu de chaque champ DS contient une information qui est codée de la manière suivante :
- un champ DS effacé (ne contenant que des 1) signifie que le bloc physique PB correspondant est effacé,
- un champ DS programmé (ne contenant que des 0) signifie que le bloc physique PB correspondant contient une donnée invalide,
- un champ DS partiellement programmé et contenant une valeur "1" comprise entre 1 et 4 signifie que le bloc physique PB correspondant contient la donnée du bloc logique d'index "1" dans la page logique dont l'adresse LPA figure dans le descripteur.

Dans un mode de réalisation, la taille des champs des descripteurs est par exemple la suivante :
- DPPA : 2 octets, avec une valeur utile comprise entre 0 et FFFE, la valeur FFFF étant réservée à l'identification d'un descripteur libre (i.e. dans l'état effacé),
- WC : 3 octets
- LPA : 2 octets, avec une valeur utile comprise entre 0 et FFFE, la valeur FFFF étant réservée à l'identification d'une page physique libre (i.e. qui n'est pas encore associée à une adresse logique),
- DS : 1 octet plus 1 octet redondant de même valeur.

La taille d'un descripteur est dans ce cas de 15 octets, et une page physique de 256 octets de la zone mémoire A2 peut recevoir 16 descripteurs, avec 16 octets résiduels disponibles pour coder un en-tête de page d'une manière qui sera décrite plus loin.

Lors de la première utilisation de la mémoire, le programme NVM configure les descripteurs de manière que chaque page physique de la zone mémoire A1 soit associée à un descripteur. Le champ WC, décrit plus loin, est également configuré lors de la première utilisation de la mémoire. A ce stade, comme aucune donnée n'a été écrite dans la zone mémoire A1, les descripteurs ne sont associés à aucune page logique et le champ LPA est laissé dans l'état effacé. De même, les champs DS sont laissés dans l'état effacé.

La figure 2 est une "photographie" à un instant donné des zones mémoires A1 et A2 et de la mémoire virtuelle. Les données et des métadonnées qui y sont représentées à titre d'exemple sont codées en hexadécimal et sont réduites à un octet pour simplifier le dessin. Ainsi, dans le dessin, une donnée ou une métadonnée peut présenter des valeurs allant de 00 (donnée ou métadonnée dont tous les bits sont programmés) à FF (donnée ou métadonnée entièrement effacée), les valeurs intermédiaires étant composées de bits programmés (0) et de bits effacés (1).

La mémoire virtuelle étant une mémoire "idéale", elle ne comporte que des données valides. On y trouve des données DT1 c, DT2 et DT3 enregistrées respectivement dans les blocs logiques LB1, LB4 et LB2 de la page logique LP1 d'adresse 01. Tous les autres blocs logiques sont égaux à FF, ce qui signifie qu'ils n'ont pas reçu de données.

On retrouve les données valides DT1 c, DT2 et DT3 dans la zone mémoire A1. La donnée DT2 est enregistrée dans le bloc PB3 de la page DPP0 d'adresse 00, et la donnée DT3 est enregistrée dans le bloc PB4 de cette page. La donnée DT1 c est enregistrée dans le bloc PB1 de la page physique DPP2 d'adresse 02. On trouve également dans la zone mémoire A1 des données invalides DT1a, DT1 b stockées dans les blocs PB1 et PB2 de la page physique DPP0.

Le lien entre l'emplacement des données dans la mémoire physique A1 et leur emplacement dans la mémoire virtuelle est assuré par les descripteurs, au moyen des champs décrits plus haut. Les descripteurs indiquent également le statut des données (valide ou invalide).

Ainsi, la zone mémoire A2 contient un descripteur DSC0 associé à la page DPP0 dans lequel :
- le champ DPPA contient l'adresse "00", ce qui signifie que le descripteur est associé à la page DPP0,
- le champ LPA contient l'adresse "01" et désigne la page logique LP1 de la mémoire virtuelle, ce qui signifie que des données de la page logique LP1 sont enregistrées dans la page physique DPP0,
- le champ DS(PB1) est égal à 00, ce qui signifie que le bloc physique PB1 de la page DPP0 contient une donnée invalide,
- le champ DS(PB2) est égal à 00, ce qui signifie que le bloc physique PB2 de la page DPP0 contient une donnée invalide,
- le champ DS(PB3) est égal à 04, ce qui signifie que le bloc physique PB3 de la page DPP0 contient une donnée valide située dans le quatrième bloc logique LB4 de la page logique LP1 (soit DT2),
- le champ DS(PB4) est égal à 02, ce qui signifie que le bloc physique PB4 de la page DPP0 contient une donnée valide située dans le deuxième bloc logique LB4 de la page logique LP1 (soit DT3).

La zone mémoire A2 contient également un descripteur DSC2 associé à la page DPP2 dans lequel :
- le champ DPPA contient l'adresse "02", ce qui signifie que le descripteur est associé à la page DPP2,
- le champ LPA contient l'adresse "01" et désigne la page logique LP1 de la mémoire virtuelle, ce qui signifie que des données de la page logique LP1 ont également été enregistrées dans la page physique DPP2,
- le champ DS(PB1) est égal à 01, ce qui signifie que le bloc physique PB1 de la page DPP2 contient une donnée valide située dans le premier bloc LB1 de la page logique LP1 (soit DT1c),
- les champs DS(PB2), DS(PB3) et DS(PB4) sont égaux à FF, ce qui signifie que les blocs physiques PB2, PB3, PB4 de la page DPP2 ne contiennent pas de données.

La zone mémoire A2 comprend également les autres descripteurs DSC2... DSCN des autres pages physiques dont le champ DPPA comprend l'adresse de la page associée et dont les champs LPA, DS(PB1), DS(PB2), DS(PB3), DS(PB4) sont effacés (égaux à FF), ce qui signifie que toutes les autres pages de la zone mémoire A2 ne contiennent pas de données.

L'ensemble des descripteurs forme donc l'équivalent d'une base de données compacte qui permet à chaque instant de savoir à quel bloc logique appartient telle donnée dans tel bloc physique, et de savoir si la donnée est valide ou invalide.

La structure des métadonnées ayant été décrite, on décrira maintenant les aspects de l'invention relatifs à l'utilisation dynamique des descripteurs et à leur configuration pendant des opérations de programmation de la mémoire.

### Exemple de séquence de programmation de données

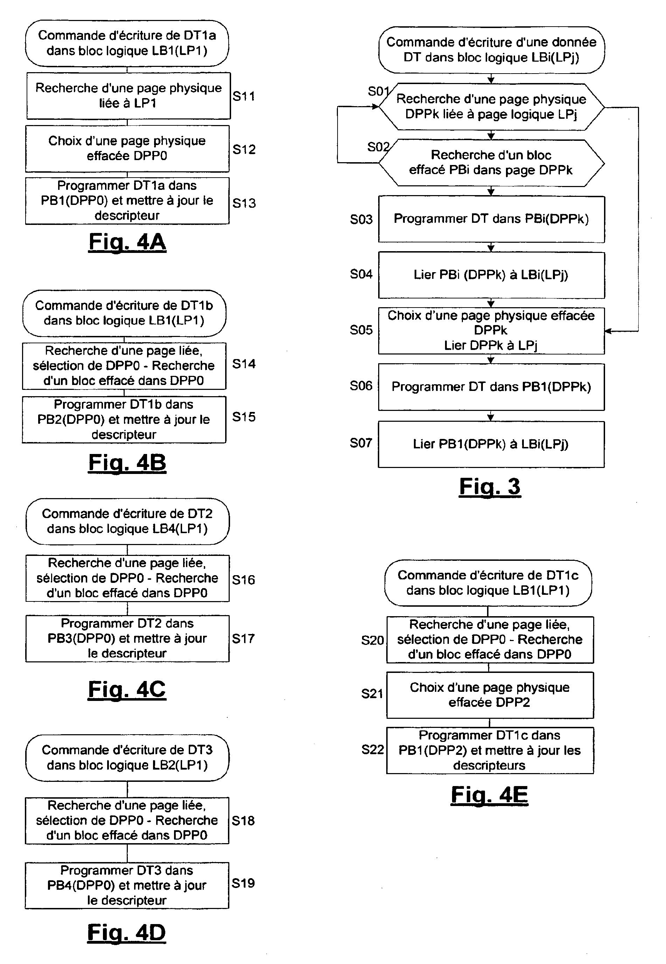

La figure 3 est un organigramme décrivant de manière simplifiée l'exécution d'une opération de programmation d'une donnée dans un bloc logique LBi(LPj) d'une page logique LPj. Au cours d'une étape S01, le programme VPG recherche une page physique DPPk liée à la page logique LPj en parcourant les champs LPA des descripteurs. Lorsque la page DPPk est trouvée, le programme VPG recherche un bloc physique effacé PBi dans la page DPPk en parcourant les champs DS du descripteur, jusqu'à trouver un champ DS égal à FF, indiquant que le bloc est effacé. Le rang du champ DS dans le descripteur permet au programme VPG de déduire l'index du bloc physique dans la page DPPk dont l'adresse figure dans le champ DPPA, et lui permet ainsi de reconstituer l'adresse du bloc, en ajoutant l'index à l'adresse DPPA. Au cours d'une étape S03, le programme VPG programme la donnée DT dans le bloc physique PBi de la page DPPk. Au cours d'une étape S04, le programme VPG lie le bloc physique PBi de la page DPPk au bloc logique LBi de la page logique LPj en programmant, dans le champ DS du descripteur se rapportant au bloc PBi, l'index du bloc logique LBi dans la page LPj. Dans une structure de mémoire virtuelle à 4 blocs par page, cet index correspond aux deux bits de poids faible de l'adresse du bloc logique LBi telle que fournie avec la commande d'écriture.

Il peut se produire qu'à l'étape S02 le programme VPG ne trouve pas de champ DS effacé, ce qui signifie que la page physique ne comporte pas de bloc disponible pour écrire la donnée. Dans ce cas, le programme VPG retourne à l'étape S01 pour rechercher dans les descripteurs une nouvelle page physique liée à la page logique LPj.

Il peut également se produire qu'à l'étape S01 le programme VPG ne trouve pas de page physique DPPk liée à page logique LPj. Dans ce cas, le programme VPG va à une étape S05 où il choisit un descripteur associé à une page physique valide DPPk qui n'est liée à aucune page logique (champ LPA effacé) et est donc dans l'état effacé. Le programme VPG lie la page physique à la page logique LPj en programmant l'adresse de la page logique dans le champ LPA de son descripteur. Ensuite, au cours d'une étape S06, le programme VPG programme la donnée DT dans le premier bloc physique PB1 de la page DPPk. Au cours d'une étape S07, le programme VPG lie le bloc physique PB1 au bloc logique LBi en programmant l'index du bloc logique dans le premier champ DS du descripteur.

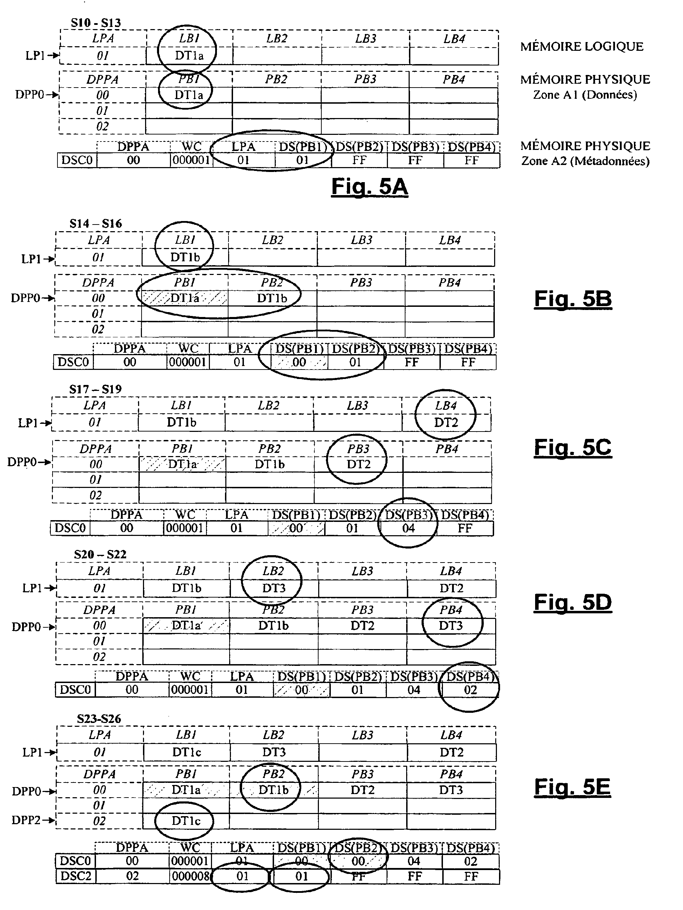

Les organigrammes représentés sur les figures 4A, 4B, 4C, 4D et 4E décrivent de manière simplifiée les étapes de programmation des données DT1 a, DT1 b, DT1 c, DT2, DT3 conduisant à la configuration de la mémoire physique représentée sur la figure 2. Les figures 5A, 5B, 5C, 5D et 5E illustrent ces étapes et montrent comment la configuration des zones mémoire A1 et A2 évolue au fur et à mesure de la programmation des données, jusqu'à obtenir la configuration de la figure 5E, qui est identique à celle de la figure 2.

L'organigramme de la figure 4A décrit des étapes d'exécution d'une commande d'écriture d'une donnée DT1a dans le bloc logique LB1(LP1) (premier bloc logique de la page logique LP1). Au cours d'une étape S11 le programme VPG recherche dans les descripteurs une page physique liée à LP1 et n'en trouve pas (dans cet exemple, la mémoire est supposée entièrement vierge). Au cours d'une étape S12 le programme VPG choisit la page physique effacée DPP0 et met à jour le descripteur DSC0 de cette page en programmant la valeur 01 dans le champ LPA afin de la lier à la page logique LP1. Au cours d'une étape S13, le programme VPG programme la donnée DT1a dans le bloc PB1(DPP0), Cf. Fig. 5A, et met à jour le descripteur DSC0 en programmant dans le champ DS(PB1) la valeur 01 représentant l'index du bloc logique LB1(LP1)).

L'organigramme de la figure 4B décrit des étapes d'exécution d'une commande écriture de la donnée DT1 b dans le même bloc logique LB1(LP1). Au cours d'une étape S14 le programme VPG recherche dans les descripteurs une page physique liée à la page logique LP1, trouve la page DPP0 puis recherche dans son descripteur un bloc physique effacé et trouve le champ DS(PB2) effacé. Au cours d'une étape S15, le programme VPG programme la donnée DT1 b dans le bloc physique PB2(DPP0), programme tous les bits du champ DS(PB1) du descripteur pour invalider la donnée DT1a présente dans le bloc PB1, et programme la valeur 01 dans le champ DS(PB2), Cf. Fig. 5B, ce qui signifie que la donnée valide DT1 b du bloc logique LB1(LP1) se trouve maintenant dans le bloc physique PB2(DPPO).

L'organigramme de la figure 4C décrit des étapes d'exécution d'une commande écriture de la donnée DT2 dans le bloc logique LB4(LP1). Au cours d'une étape S16, le programme VPG recherche dans les descripteurs une page physique liée à la page logique LP1, trouve la page DPP0 puis recherche au moyen des descripteurs un bloc physique effacé dans la page DPP0. Au cours d'une étape S17, le programme VPG programme la donnée DT2 dans le bloc physique PB3(DPP0), puis programme la valeur 04 dans le champ DS(PB3) du descripteur, Cf. Fig. 5C.

L'organigramme de la figure 4D décrit des étapes d'exécution d'une commande d'écriture de la donnée DT3 dans le bloc logique LB2(LP1). Au cours d'une étape S16, le programme VPG recherche dans les descripteurs une page physique liée à la page logique LP1, trouve la page DPP0 puis recherche au moyen des descripteurs un bloc physique effacé dans la page DPP0. Au cours d'une étape S17, le programme VPG programme la donnée DT3 dans le bloc physique PB4(DPP0), puis programme la valeur 024 dans le champ DS(PB4) du descripteur, Cf. Fig. 5D.

L'organigramme de la figure 4E décrit des étapes d'exécution d'une commande de programmation de la donnée DT1 c dans le bloc logique LB1(LP1). Au cours d'une étape S20 le programme VPG recherche dans les descripteurs une page physique liée à la page logique LP1, trouve la page DPP0 puis recherche au moyen des descripteurs un bloc physique effacé dans la page DPP0. La page DPP0 étant entièrement écrite, le programme VPG recherche une page effacée à l'étape S21, choisit la page physique DPP2 et met à jour le descripteur DSC2 de cette page en programmant la valeur 01 dans le champ LPA afin de la lier à la page logique LP1. Au cours d'une étape S22, le programme VPG programme la donnée DT1c dans le bloc physique PB1(DPP2), met à jour le descripteur DSC0 en programmant tous les bits du champ DS(PB2) du descripteur DSC0 afin d'invalider la donnée DT1 b présente dans le bloc physique PB2(DPP0), et met à jour le descripteur DSC2 en programmant la valeur 01 dans le champ DS(PB1).

Il sera noté que l'ordre des opérations décrites ci-dessus est arbitraire en ce qui concerne la mise à jour des descripteurs. Ces opérations peuvent être conduites selon un ordre déterminé dans le cadre de la mise en oeuvre d'un procédé de protection contre les interruptions de tension d'alimentation, qui sera décrit plus loin.

Comme cela apparaît à la lumière des exemples décrits, les données d'une page logique peuvent être stockées dans plusieurs pages physiques et des données écrites successivement dans le même bloc logique peuvent rester dans la mémoire physique. Il ne peut toutefois y avoir qu'une seule donnée valide par bloc logique, de sorte que chaque programmation d'une donnée d'un bloc logique entraîne obligatoirement l'invalidation de la donnée précédemment programmées.

Par ailleurs, en supposant que le processus d'écriture illustré sur les figures 5A à 5E se poursuive et que les blocs logiques LB3, LB4 de la page LP1 reçoivent de nouvelles données, les données DT2, DT3 présentes dans la page physique DPP0 seront invalidées et la page DPP0 ne contiendra que des données invalides. Une telle page sera ensuite invalidée puis effacée par le programme VPG, pour libérer de l'espace mémoire.

L'effacement d'une page implique l'attribution d'un nouveau descripteur à la page et l'invalidation du descripteur associé à cette page. L'écriture de métadonnées dans la zone mémoire A2 étant du type à effacement différé, et consistant donc dans une programmation de données, il n'est en effet pas envisageable d'effacer le descripteur actuel de la page pour remettre à "FF" les champs LPA et DS. Ainsi, le programme VPG affecte un nouveau descripteur à la page et invalide l'ancien descripteur en mettant son champ WC à 0.

Il sera noté que la structure compacte de descripteur choisie dans ce mode de réalisation du procédé de l'invention impose qu'une page physique ne comporte que des données appartenant à une même page logique. Dans des variantes de réalisation de l'invention, une structure de descripteur de type "descripteur de bloc" pourrait être prévue et permettrait d'associer n'importe quel bloc de n'importe quelle page logique à n'importe quel bloc physique de n'importe quelle page physique. Une telle structure de descripteur de bloc serait toutefois volumineuse car chaque descripteur de bloc devrait comprendre les adresses DPPA et LPA des pages physique et logique auxquelles il est associé. Les descripteurs de page incluant une information sur le contenu des blocs de la page forment ainsi un moyen avantageux en termes de compacité de la zone mémoire A2.

### III- Second aspect de l'invention : gestion de l'usure des pages

Un inconvénient de l'écriture de données à effacement différé et que le programme VPG pourrait arbitrairement favoriser le cyclage de certaines pages au détriment d'autres pages. Il pourrait arriver que la même page soit arbitrairement utilisée plus souvent que d'autres, et donc plus souvent effacée que les autres. Par exemple, on a vu dans ce qui précède qu'à certaines étapes du processus de programmation de données, par exemples les étapes S05 en figure 3 et S21 en figure 4E, le programme VPG est amené à choisir des pages effacées pour y écrire de nouvelles données.

Selon un aspect de l'invention, des métadonnées sont également utilisées pour assurer un suivi du "cyclage" des pages (c'est-à-dire le nombre de cycles d'effacement qu'elles subissent). Plus particulièrement, un compteur d'usure WC est attribué à chaque page physique de la zone mémoire A1, et est enregistré dans la zone mémoire A2. Le compteur WC peut être agencé dans un descripteur d'usure dédié dans lequel figure l'adresse de la page. Toutefois, dans le cadre de la mise en oeuvre du premier aspect de l'invention, où des descripteurs de pages sont utilisés, il est avantageux de placer ce compteur WC dans la structure de descripteur, comme représenté sur la figure 2.

Le compteur WC est par exemple codé sur 3 octets, comme indiqué plus haut. Lors de la première utilisation de la mémoire, le programme VPG initialise le compteur WC de chaque page physique de données en y programmant une valeur de comptage égale à 000001 (notation hexadécimale) au moment de la première configuration des descripteurs. Le programme VPG incrémente ensuite le compteur après chaque effacement de la page. Le compteur WC accompagne ainsi la page pendant toute la durée de vie de la mémoire. Sur les figures 5A à 5E, on voit par exemple que le compteur WC du descripteur DSC0 de la page DPP0 est égal à 000001, ce qui signifie que la page n'a pas encore été effacée. Sur la figure 5E, le compteur WC du descripteur DSC2 de la page DPP2 est égal à 000008, ce qui signifie que la page a été effacée 7 fois.

Grâce au compteur WC, le cyclage des pages de données peut être contrôlé par le programme VPG de manière dynamique et/ou statique, afin d'homogénéiser l'usure des pages sur l'ensemble du plan mémoire. Une gestion dynamique de l'usure comprend par exemple, lors de l'écriture de données dans des pages physiques effacées, une étape au cours de laquelle le programme VPG sélectionne des pages effacées ayant subi le plus faible nombre de cycles d'effacement. Une gestion statique de l'usure comprend par exemple une tâche de fond (tâche en arrière-plan) comprenant des étapes de déplacement de données valides d'une page ayant un subi un faible nombre de cycles d'effacement vers une page ayant subi plus de cycles d'effacement, afin de libérer une page faiblement cyclée pour l'utiliser plus intensivement par la suite.

Comme indiqué plus haut, l'effacement d'une page de données DPP est accompagné de l'attribution d'un nouveau descripteur à la page, ce qui implique l'invalidation du descripteur associé à cette page, consistant à mettre le champ WC à 0. Afin de ne pas perdre "l'historique" de l'usure de la page, le compteur WC d'un descripteur destiné à être invalidé est préalablement transféré dans le nouveau descripteur de la page effacée.

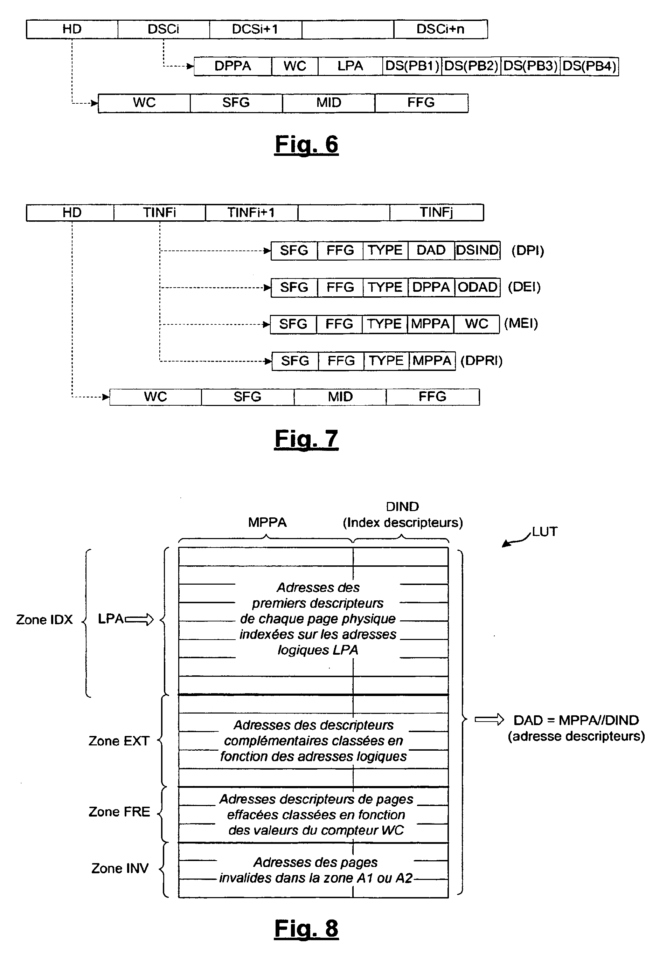

Avantageusement, l'usure des pages de métadonnées est également surveillée et homogénéisée par le programme VPG en attribuant à celles-ci un compteur WC, agencé ici à l'intérieur des pages de métadonnées, dans un champ d'en-tête HD ("Header") de ces pages. Comme illustré sur la figure 6, une page de descripteurs comprend le champ d'en-tête HD et une pluralité de descripteurs DSCi, DSCi+1,...DSCi+n comprenant chacun les champs DPPA, WC, LPA, DS(PB1), DS(PB2), DS(PB3), DS(PB4). Le champ d'en-tête comprend
- le compteur WC, de 3 octets,
- un drapeau de début SFG, par exemple de 1 octet,
- un champ d'identification MID (Metadata Identifier), par exemple codé sur 3 octets, et
- un drapeau de fin FFG, par exemple de 1 octet.

Les drapeaux SFG, FFG sont prévus en relation avec un aspect de l'invention décrit plus loin. Le champ d'identification MID est codé avec une valeur déterminée, par exemple "3C", qui indique que la page de métadonnées contient des descripteurs. Le champ MID est également utilisé pour invalider la page de descripteurs, lorsque celle-ci ne contient que des descripteurs invalides. Dans ce cas, le champ MID est entièrement programmé et sa valeur est "00" en notation hexadécimale. Enfin, lorsque le champ MID est égal à "FF", cela signifie que la page de métadonnées est disponible et peut être utilisée pour enregistrer des descripteurs ou toute autre structure de métadonnées qui sera décrite plus loin.

Après un certain usage de la mémoire, une page de descripteurs peut ne comporter que des descripteurs invalides. Il s'agit de descripteurs se rapportant tous à des pages contenant des données invalides. Le programme VPG peut être configuré pour conduire une tâche de fond qui vise à trouver les pages de descripteurs invalides, puis à les effacer pour libérer de l'espace mémoire dans la zone mémoire A2. Dans ce cas, le compteur WC de la page de descripteurs devant être effacée est préalablement mis de côté puis reprogrammé dans le champ d'en-tête de la page de descripteurs une fois celle-ci effacée.

Une gestion dynamique de l'usure des pages de métadonnées peut également être prévue, et comprend par exemple, lors de l'écriture de métadonnées dans des pages physiques effacées de la zone mémoire A2, une étape au cours de laquelle le programme VPG sélectionne des pages effacées ayant subi le plus faible nombre de cycles d'effacement. Une gestion statique de l'usure des pages de métadonnées peut aussi être prévue et comprend par exemple une tâche de fond (tâche en arrière-plan) comprenant des étapes de déplacement de descripteurs d'une page ayant un subi un faible nombre de cycles d'effacement vers une page ayant subi plus de cycles d'effacement.

Des caractéristiques plus détaillées de mise en oeuvre de cet aspect de l'invention seront décrites plus loin, dans le cadre de la description d'autres aspects de l'invention.

### IV- Troisième aspect de l'invention : protection des données contre des interruptions de la tension d'alimentation

La gestion de l'arrachement ("tearing") et des coupures de tension qu'il occasionne, nécessite classiquement la prévision de données spécifiques permettant d'assurer un suivi des processus de programmation et d'effacement. Au redémarrage de la mémoire, ces données sont lues et permettent de détecter une interruption de processus afin de replacer la mémoire dans son état initial et ainsi corriger les effets de la coupure de tension. A l'instar des données d'étiquetage classiques, les données de suivi de processus sont, dans l'art antérieur, concaténées aux données d'application et se complexifient de façon notable lorsque l'on passe d'une programmation par page à une programmation par bloc. On doit ainsi concaténer avec chaque bloc de données d'application non seulement des données d'étiquetage mais également des données de suivi de processus. De plus l'étiquetage des données d'application avec des données de suivi de processus n'est pas une méthode infaillible, il subsiste des cas d'incertitude ou les cellules mémoire recevant les données de suivi de processus sont dans un état intermédiaire entre l'état programmé et l'état effacé, et peuvent être lues comme comportant un "1" ou un "0" en fonction de paramètres externes tels la température et la tension d'alimentation du circuit, ce qui peut conduire à un diagnostic erroné. Les limites des techniques connues résident dans le fait que les données de suivi de processus sont concaténées aux données d'application et se voient donc attribuer un emplacement mémoire figé ne permettant pas de mettre en oeuvre des solutions visant à prévenir les erreurs de diagnostic dues aux états intermédiaires.

Selon cet aspect de l'invention, des métadonnées de la zone mémoire A2 sont affectées au suivi de processus. A l'instar des métadonnées permettant l'identification des données dans la zone mémoire A1, qui sont configurées sous forme de descripteurs, les métadonnées affectées au suivi de processus sont configurées sous forme de structures spécifiques appelées "structures d'information temporaire" TINF représentées sur la figure 7. Ces structures de métadonnées sont programmées dans des pages de métadonnées spécifiques appelées "pages d'informations temporaires" dont la structure est également représentée sur la figure 7.

Une page d'informations temporaires comprend un champ d'en-tête HD suivi d'une pluralité de structures d'information temporaire TINFi, TINFi+1,... TINFj. Le champ d'en-tête est identique à celui d'une page de descripteurs et comprend ainsi :
- le compteur WC de la page,
- le drapeau SFG,
- le champ d'identification MID, et
- un drapeau FFG, par exemple de 1 octet.

Le champ d'identification MID est codé avec une valeur déterminée, par exemple "F0", qui indique que la page de métadonnées est une page d'informations temporaires. Le champ MID est également utilisé pour invalider la page d'informations temporaires, lorsque celle-ci ne contient que des structures d'information temporaire invalides. Dans ce cas, le champ MID est entièrement programmé et sa valeur est égale à "00" en notation hexadécimale.

Dans un mode de réalisation, le procédé de l'invention prévoit :
- une structure d'information temporaire DPI ("Data Programming Information") pour le suivi du processus de programmation d'un bloc physique de données dans la zone mémoire A1,
- une structure d'information temporaire DEI ("Data Erasing Information") pour le suivi du processus d'effacement d'une page physique de données dans la zone mémoire A1,
- une structure d'information temporaire MEI ("Metadata Erasing Information") pour le suivi du processus d'effacement d'une page de métadonnées dans la zone mémoire A2,
- une structure d'information temporaire DPRI ("Descriptor Page Rearranging Information") pour le suivi d'un processus de réarrangement de descripteurs dans la zone mémoire A2.

Ces structures d'information temporaire seront maintenant décrites plus en détail en relation avec leur utilisation.

### Suivi du processus de programmation d'un bloc physique de données dans la zone mémoire A1

La structure DPI comporte les champs suivants :
- un drapeau de début "SFG" ("Start Flag"), par exemple de 1 octet
- un drapeau de fin "FFG" ("Final Flag"), par exemple de 1 octet,
- un champ "TYPE", par exemple de 1 octet, permettant d'identifier la structure DPI,
- un champ "DAD" ("Descriptor Address"), par exemple de 1 octet,
- un champ "DSIND" ("DS Index"), par exemple de 1 octet,

Le champ DAD reçoit l'adresse du descripteur de la page physique dans laquelle les données sont programmées. Cette adresse comprend l'adresse MPPA de la page de métadonnées dans laquelle se trouve le descripteur, exprimée sous forme d'index calculé relativement à la première page de la seconde zone mémoire A2, et l'index DIND du descripteur dans la page de métadonnées. Le champ DSIND reçoit l'index, dans le descripteur, du champ DS concerné par l'opération de programmation. Comme 4 bits suffisent pour désigner les quatre valeurs possibles de l'index dans une mémoire virtuelle à quatre blocs par page logique, les quatre autres bits du champ DSIND peuvent être utilisés pour stocker la valeur devant être programmée dans le champ DS. Comme indiqué plus haut cette valeur est l'index, dans la page logique, du bloc logique dont la donnée doit être programmée dans le bloc physique.

Le programme VPG configure la structure DPI en plusieurs étapes avant la programmation d'une donnée dans un bloc physique de la zone mémoire A1 :
1) programmation de la moitié des bits du drapeau SFG,
2) programmation du champ TYPE, du champ DAD et du champ DSIND,
3) programmation des autres bits du drapeau SFG
L'opération de programmation du bloc est ensuite réalisée. Lorsque cette opération est terminée, le programme VPG programme le drapeau de fin FFG.

Le drapeau de début SFG étant programmé en deux étapes, il est équivalent à deux drapeaux, à savoir un premier drapeau de début de processus et un second drapeau de début de processus, permettant d'encadrer le processus de programmation des champs TYPE, DAD et DSIND de la structure d'information temporaire.

### Suivi du processus d'effacement d'une page physique de données dans la zone mémoire A1

La structure DEI comporte les champs suivants :
- un drapeau de début "SFG" ("Start Flag"), par exemple de 1 octet,
- un drapeau de fin "FFG" ("Final Flag"), par exemple de 1 octet,
- un champ "TYPE", par exemple de 1 octet, permettant d'identifier la structure DEI,
- un champ "DPPA" ("Data Physical Page Address"), par exemple de 2 octets,
- un champ "ODAD" ("Old Descriptor Address"), par exemple de 2 octets,

Le champ DPPA déjà décrit plus haut reçoit l'adresse de la page physique de données à effacer, sous forme d'index. Le champ ODAD contient l'adresse de l'ancien descripteur, soit le descripteur de la page avant son effacement. En effet, comme indiqué plus haut, l'effacement d'une page est nécessairement accompagné de la programmation d'un nouveau descripteur.

Le programme VPG configure la structure DEI en plusieurs étapes avant l'effacement d'une page :
1) programmation de la moitié des bits du drapeau SFG,
2) programmation du champ TYPE, du champ DPPA et du champ OAD,
3) programmation des autres bits du drapeau SFG,

Lorsque l'opération d'effacement de la page de données est terminée, le programme VPG programme le drapeau de fin FFG.

### Suivi du processus d'effacement d'une page de métadonnées dans la zone mémoire A2

La structure MEI comporte les champs suivants :
- un drapeau de début "SFG" ("Start Flag"), par exemple de 1 octet,
- un drapeau de fin "FFG" ("Final Flag"), par exemple de 1 octet,
- un champ "TYPE", par exemple de 1 octet, permettant d'identifier la structure MEI,
- un champ "MPPA" ("Metadata Physical Page Address"), par exemple de 2 octets,
- un champ "WC" ("Wear Counter "), de 3 octets.

Le champ MPPA déjà décrit plus haut reçoit l'adresse de la page de métadonnées à effacer, sous forme d'index. Le champ WC reçoit la valeur du compteur d'usure WC de la page de métadonnées à effacer.

Le programme VPG configure la structure MEI en plusieurs étapes avant l'effacement d'une page de métadonnées :
1) programmation de la moitié des bits du drapeau SFG,
2) programmation du champ TYPE, du champ MPPA et du champ WC,
3) programmation des autres bits du drapeau SFG.

Lorsque l'opération d'effacement de la page est terminée, le programme VPG recopie la valeur du compteur WC dans le champ WC qui se trouve dans l'en-tête de la page effacée, puis programme le drapeau de fin FFG.

### Suivi d'un processus de réarrangement de descripteurs dans la zone mémoire A2

Le réarrangement de descripteurs est une tâche d'arrière-plan pouvant être conduite par le programme VPG pour regrouper des descripteurs valides dans la même page de descripteurs. Elle implique l'invalidation des descripteurs initiaux. Cette tâche permet de faire apparaître des pages de descripteurs ne contenant que des descripteurs invalides, qui pourront ensuite être effacées, et d'augmenter la concentration de descripteurs valides dans les pages valides de descripteurs. Cette tâche peut également être effectuée dans le cadre d'une gestion statique de l'usure de pages de métadonnées, pour transférer des descripteurs dans des pages ayant subi plus de cycles d'effacement, ayant un compteur WC de plus forte valeur.

Comme les descripteurs doivent être protégés contre les coupures de tension pendant leur déplacement d'une page à une autre, la structure d'information temporaire DPRI est prévue pour couvrir cette tâche. Elle comporte les champs suivants :
- un drapeau de début "SFG" ("Start Flag"), par exemple de 1 octet
- un drapeau de fin "FFG" ("Final Flag"), par exemple de 1 octet,
- un champ "TYPE", par exemple de 1 octet, permettant d'identifier la structure DPRI,
- un champ "MPPA" ("Metadata Physical Page Address"), par exemple de 2 octets.

Le champ MPPA reçoit l'adresse MPPA de la page de métadonnées dans laquelle des descripteurs valides vont être lus et déplacés dans une nouvelle page, exprimé sous forme d'index.

Le programme VPG configure la structure d'information temporaire MEI en plusieurs étapes :
1) programmation de la moitié des bits du drapeau SFG,
2) programmation du champ TYPE et du champ MPPA,
3) programmation des autres bits du drapeau SFG.

Ensuite, le programme VPG déplace les descripteurs valides vers l'autre page, puis invalide la page de départ en programmant tous les bits du champ MID de la page, comme décrit plus haut. La page sera effacée par une autre tâche d'arrière-plan, ou tâche de "collecte de déchets" ("Garbage Collection"), assurant l'effacement de pages invalides.

Lorsque l'opération de transfert des descripteurs est achevée, le programme VPG programme le drapeau de fin FFG de la structure d'information temporaire.

### Suivi du processus de programmation de descripteurs

En sus de l'information figurant dans les structures d'information temporaire, ce suivi est également assuré au moyen de la redondance d'octets dans les champs DS des descripteurs, décrite plus haut. Dans chaque champ DS, l'octet redondant est programmé après la programmation du premier octet du champ. Si une coupure d'alimentation intervient pendant la programmation de ce champ, la différence entre le premier et le second octet permet de détecter l'interruption du processus de programmation.

### Suivi d'un processus de programmation des en-têtes des pages de métadonnées

Les drapeaux de début SFG et les drapeaux de fin FFG prévus dans les en-têtes des pages de métadonnées permettent également au programme VPG de détecter qu'une coupure de tension est intervenue pendant la programmation des en-têtes, le drapeau de fin de l'en-tête étant programmé en dernier lieu.

### Exécution d'un algorithme anti-arrachement à la mise sous tension

A la remise sous tension, le programme VPG exécute un algorithme "anti-arrachement" ("anti-tearing", i.e. qui vise à contrer les effets d'une coupure de tension) et analyse les drapeaux SFG, FFG présents dans les structures d'information temporaire, dans les en-têtes des pages de descripteurs et dans les en-têtes des pages d'informations temporaires, pour détecter une éventuelle anomalie. Il recherche également des anomalies de redondance d'octets dans les descripteurs si une incohérence a été détectée dans les drapeaux. Un diagnostic est ensuite établi, pour définir, si nécessaire, les actions à conduire afin de restaurer la mémoire dans son état initial, c'est-à-dire la configuration dans laquelle elle était avant le déclenchement de l'opération (programmation ou effacement) interrompue par la coupure de tension.

L'analyse des métadonnées d'information temporaire est par exemple conduite dans l'ordre suivant :
1) vérification de la validité de tous les en-têtes de pages,
2) recherche des deux dernières structures d'information temporaire,
3) fixation des pages instables détectées par reprogrammation des bits déjà programmés ou recopie de ces pages et invalidation des pages initiales,
4) analyse des structures d'information temporaire et traitement de celles-ci.

Une anomalie est par exemple constatée lorsque deux drapeaux d'une même structure (information temporaire ou en-tête) ne présentent pas la même valeur, ce qui signifie qu'un processus a été interrompu. Le champ TYPE des structures d'information temporaire permet de savoir de quel processus il s'agit. Dans l'hypothèse où l'anomalie concerne une structure d'information temporaire, le programme VPG recopie cette structure dans une page d'informations temporaires de la zone mémoire A2 pour la stabiliser, avant de procéder à une analyse des données pour établir un diagnostic et avant de définir les actions réparatrices éventuelles. Lorsque la structure d'information temporaire en défaut a été recopiée, la structure d'information temporaire initiale est neutralisée par programmation de ses bits effacés (passage de 1 à 0) et surprogrammation de ses bits programmés.

Par exemple, un drapeau de fin FFG peut se trouver dans un état intermédiaire si une coupure de tension est intervenue alors que le programme VPG était en train de le programmer. Un tel drapeau peut être lu égal à "1" à la mise sous tension, ce qui est considéré comme une anomalie puisque le drapeau de début est programmé et est donc égal à 0. Toutefois, ce même drapeau de fin peut ensuite être lu égal à 0 à la mise sous tension suivante, si une nouvelle coupure d'alimentation intervient après le redémarrage de la mémoire, avant que le programme VPG n'ait eu le temps d'établir un diagnostic. Ce changement de la valeur lue du drapeau peut dépendre de paramètres externes tels la température ou la tension d'alimentation du circuit.

Le fait de recopier la structure d'information temporaire et de neutraliser la structure d'information temporaire initiale considérée comme "potentiellement instable" (car on ne peut pas savoir si elle l'est réellement) permet donc de la stabiliser par mesure de précaution. Si une nouvelle coupure d'alimentation se produit pendant la programmation de la copie de la structure d'information temporaire, de sorte que la nouvelle structure présente elle-même un défaut, alors une copie de la nouvelle structure d'information temporaire lors de la prochaine mise sous tension permettra de la stabiliser et d'établir un diagnostic. Ainsi, le fait de recopier la structure d'information temporaire et de neutraliser la structure d'information temporaire initiale, permet d'éviter les erreurs de diagnostic dues aux cellules mémoire dans un état intermédiaire.

Il sera noté qu'une telle opération de copie est impossible à réaliser dans une mémoire conventionnelle où les données de suivi de processus sont programmées dans des champs de taille figée prévus en début ou en fin de page. Le fait de bénéficier d'un espace mémoire dédié aux métadonnées et de pouvoir reprogrammer des structures d'information temporaire pour les stabiliser, offre ainsi des avantages insoupçonnés.

Des descripteurs présentant une anomalie peuvent également être recopiés. Si un descripteur présente un défaut dans la redondance d'octets (octets n'ayant pas la même valeur), le descripteur est recopié pour le stabiliser et le descripteur initial est invalidé. Cette opération n'est toutefois effectuée que si, au moment de la coupure de tension, le descripteur en défaut était en cours de programmation en relation avec une opération de programmation d'une donnée dans un bloc physique (la nature de l'opération est déterminée par le champ "TYPE" de la structure d'information temporaire, qui doit donc être une information de type DPI).

Les champs d'en-tête présentant une anomalie ne sont par contre pas recopiés et sont simplement surprogrammés car ils ne posent pas le même problème d'instabilité et de validité : au moment où ils sont surprogrammés, l'algorithme est dans un état stable et à la prochaine mise sous tension, ils seront nécessairement reprogrammés avec la même valeur.

### V - Quatrième aspect de l'invention : prévision d'une table de correspondance pointant vers les métadonnées

Afin de simplifier le travail du processeur assurant la gestion de la mémoire, il est habituel dans l'art antérieur de faire appel à une table de correspondance placée en mémoire volatile, permettant déterminer où se trouve des pages étiquetées dans le plan mémoire. La table de correspondance comporte une liste d'étiquettes et, en relation avec chaque étiquette, une adresse physique de la donnée portant cette étiquette. Dans le cadre de la mise en oeuvre d'un procédé d'écriture par bloc avec effacement différé, l'augmentation du nombre d'étiquettes entraîne également une complexification proportionnelle de la structure de la table de correspondance et de la taille de la mémoire volatile. Une table de correspondance de taille compacte peut donc être souhaitée.

Dans un mode de réalisation de l'invention, le programme VPG utilise une table de correspondance compacte LUT ("Look-Up Table") pour accéder à la mémoire NVM. La table de correspondance est enregistrée dans la mémoire volatile VM du circuit intégré (Cf. Fig. 1) et est reconstruite par le programme VPG à chaque démarrage du circuit intégré, à partir d'une lecture des métadonnées.

Selon l'invention, la table de correspondance LUT ne pointe pas vers la zone mémoire A1 où se trouvent les données, mais pointe vers la zone mémoire A2 où se trouvent les métadonnées. En d'autres termes, la table de correspondance fournit des adresses DAD de descripteurs. Ces adresses comprennent une adresse MPPA d'une page de descripteur et l'index DIND d'un descripteur dans cette page. La table de correspondance est également utilisée par le programme VPG pour gérer et mettre à jour une liste de pages invalides devant être effacées, ainsi que pour gérer et mettre à jour une liste de pages effacées.

La figure 8 représente schématiquement un exemple de structure de la table de correspondance LUT. La table de correspondance présente quatre zones distinctes, une zone IDX, une zone EXT, une zone FRE et une zone INV.

La zone IDX contient des adresses de descripteurs indexées sur les adresses logiques LPA. A chaque adresse LPAᵢ correspond l'adresse d'un descripteur valide comprenant cette adresse dans son champ LPA. La zone EXT contient également des adresses de descripteurs, mais ces adresses ne sont pas indexées sur les adresses logiques LPA et sont seulement classées par ordre croissant des adresses logiques qui figurent dans le champ LPA des descripteurs.

La zone FRE contient des adresses de descripteurs associés à des pages effacées de la zone mémoire A1, soit des descripteurs dont les champs DPA et DS sont dans l'état effacé (les champs DPPA et WC étant par contre renseignés dès la formation des descripteurs, comme décrit plus haut). Les adresses des descripteurs y sont classés par ordre croissant (ou, au choix, par ordre décroissant) des valeurs des compteurs WC qu'ils comprennent. En d'autres termes la première adresse de descripteur qui se trouve en haut de la zone FRE (ou en bas, si classement décroissant) est celle du descripteur effacé ayant la plus faible valeur de compteur WC et ayant donc subi le plus petit nombre de cycles d'effacement.

La zone INV contient des adresses de toutes les pages de données invalides présentes dans la zone mémoire A1. Cette zone est utilisée par le programme VPG pour exécuter une tâche de fond visant à libérer de l'espace mémoire par effacement de pages invalides.

### Construction de la table de correspondance

Le programme VPG construit la table de correspondance LUT à chaque mise sous tension du circuit intégré. A cet effet, il balaye toutes les pages de descripteurs et recherche, pour chaque adresse logique LPAᵢ, les descripteurs valides dont le champ LPA comprend cette adresse LPAᵢ. Le premier descripteur trouvé est placé dans la zone IDX et est associé à l'adresse logique LPAᵢ. Les autres descripteurs trouvés répondant à cette définition sont placés dans la zone EXT et sont classés par ordre croissant des adresses LPA qu'ils comportent. Lorsque toutes les adresses logiques de l'espace mémoire virtuel ont été balayées, la table de correspondance comprend dans sa zone IDX et dans sa zone EXT toutes les adresses des descripteurs valides associés à des pages physiques qui comportent au moins une donnée valide de la mémoire virtuelle.

La zone EXT est construite simultanément à ce balayage, en y enregistrant les adresses de descripteurs dont le champ LPA a été trouvé dans l'état effacé, et en les classant par valeurs croissantes (ou décroissantes) des compteurs WC qu'ils comportent. De même la zone INV peut être construite simultanément, en y enregistrant les adresses des descripteurs dont les quatre champs DS sont trouvés égaux à 0.

### Utilisation de la table de correspondance

Lorsque le programme VPG reçoit une commande de lecture ou d'écriture d'un bloc logique, l'adresse physique du bloc logique doit d'abord être déterminée pour exécuter la commande.

Dans un premier temps, le programme VPG extrait de l'adresse du bloc logique l'adresse LPAᵢ de la page logique dans laquelle se trouve le bloc logique et recherche dans la zone IDX, au moyen de cette adresse LPAᵢ, l'adresse d'un descripteur. Cette étape sera maintenant décrite.

### Recherche d'un descripteur au moyen de la zone IDX

Plusieurs cas sont envisageables :
i) La zone IDX ne contient aucun descripteur associé à l'adresse logique LPAᵢ :
   a) la commande est une commande d'écriture :
      Dans ce cas le programme VPG va dans la zone FRE et choisit l'adresse du descripteur qui se trouve en haut de la liste, pour programmer la donnée dans la page physique ayant subi le plus faible nombre de cycles d'effacement parmi toutes les pages effacées disponibles. L'adresse de cette page est déterminée par une lecture du champ DPPA du descripteur sélectionné.
   b) la commande est une commande de lecture :
      Dans ce cas, l'absence de descripteur signifie qu'aucune donnée n'a été programmée à cette adresse logique. Le programme VPG retourne alors la valeur "FF" signifiant que le bloc logique est vierge. Alternativement, le programme VPG envoie une réponse appropriée, déterminée par un protocole de communication entre le programme VPG et l'application qui l'utilise.
ii) La zone IDX contient le descripteur associé à l'adresse logique LPAᵢ et fournit une adresse de descripteur :
   a) Si la commande est une commande de lecture, le programme VPG lit le descripteur et recherche le champ DS contenant une valeur égale à l'index du bloc logique dans la page logique, et en déduit l'index dans la page physique dont l'adresse DPPA figure dans le descripteur du bloc physique contenant la donnée recherchée. Le programme VPG est alors en mesure de reconstruire l'adresse visée, en combinant l'adresse DPPA et l'index du bloc physique, et de lire la donnée. Si aucun champ DS contenant l'index du bloc logique n'est trouvé dans le descripteur, le programme VPG poursuit la recherche dans la zone EXT de la table de correspondance.
   b) Si la commande est une commande d'écriture, le programme VPG recherche le premier champ DS effacé dans le descripteur. Si le descripteur ne contient que des champs DS occupés, le programme VPG poursuit la recherche de descripteur dans la zone EXT de la table de correspondance.

### Recherche d'autres descripteurs au moyen de la zone EXT

Cette zone n'étant pas indexée, le programme VPG doit trouver lui-même le ou les descripteurs qui comportent l'adresse LPAᵢ. Comme les descripteurs y sont classés par ordre croissant des adresses logiques LPA auxquelles ils sont associés, le programme VPG utilise une méthode de recherche convergente par approches successives qui peut nécessiter de lire quelques descripteurs ne comportant pas la bonne adresse LPAᵢ mais qui lui permet rapidement de converger vers le descripteur comportant cette adresse, s'il en existe un.

Lorsque le descripteur est trouvé, le programme VPG, s'il est en train d'exécuter une commande d'écriture, procède comme il l'a fait avec le premier descripteur trouvé par l'intermédiaire de la zone IDX, et ainsi de suite jusqu'à trouver le descripteur comprenant l'adresse LPAᵢ et un champ DS effacé. Si tous les champs DS sont occupés ou invalides, le programme VPG va dans la zone FRE pour sélectionner un descripteur de page effacée.

S'il est en train d'exécuter une commande de lecture, le programme VPG procède comme il l'a fait avec le premier descripteur trouvé par l'intermédiaire de la zone IDX, et ainsi de suite jusqu'à trouver le descripteur comprenant l'adresse LPAᵢ et un champ DS comportant l'index du bloc logique devant être lu. Si aucun des champs DS ne comporte cet index, cela signifie qu'aucune donnée n'a été programmée dans ce bloc logique. Le programme VPG répond alors à la commande en renvoyant la valeur "FF" signifiant que le bloc logique est vierge ou envoie une réponse appropriée.

### Invalidation d'une donnée précédente

Lorsque la commande reçue est une commande d'écriture, il peut être nécessaire d'invalider une donnée précédente ayant la même adresse logique. En effet, il peut exister, dans un descripteur associé à l'adresse LPAᵢ, un champ DS ayant le même index et désignant ainsi un bloc physique contenant une donnée de même adresse logique. Cette donnée deviendra obsolète après programmation de la nouvelle donnée et ce champ DS devra donc être invalidé, comme cela a été indiqué plus haut en relation avec les figures 5A à 5E.

Ainsi, tout au long de la lecture des descripteurs associés à l'adresse logique LPAᵢ, le programme VPG doit aussi rechercher un descripteur associé à l'adresse cible LPAᵢ et qui comporte un champ DS contenant le même index de bloc logique que le bloc logique cible, et mémoriser l'adresse du descripteur ainsi que l'index du champ DS. Ainsi, le programme VPG ne s'arrête pas au descripteur recherché pour écrire la donnée, mais doit balayer l'ensemble des descripteurs comprenant l'adresse LPAᵢ pour s'assurer qu'il n'existe pas dans la zone mémoire A1 une donnée précédemment programmée ayant la même adresse logique.

### VI -Exemple d'architecture générale du programme VPG avec mise en oeuvre des quatre aspects de l'invention

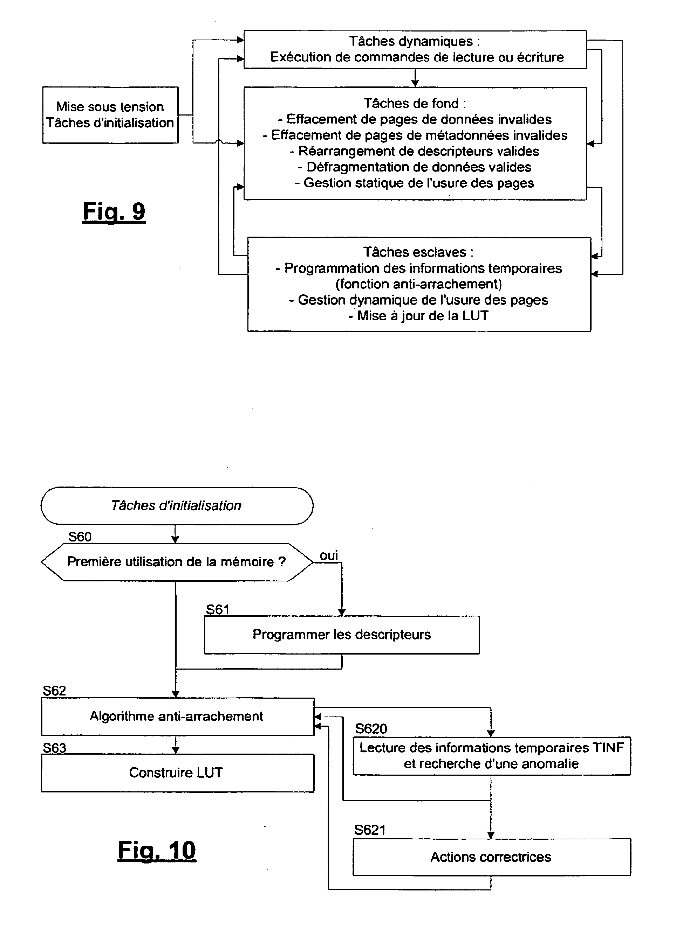

La figure 9 est une vue générale des tâches pouvant être conduites par le programme VPG, dans un mode de réalisation mettant en oeuvre les quatre aspects de l'invention. Après la mise sous tension du circuit intégré, des tâches d'initialisation sont tout d'abord effectuées. Ensuite, le programme VPG effectue des tâches dynamiques et des tâches esclaves.

### Tâche d'initialisation

Un organigramme qui résume les principales étapes de cette tâche est représenté sur la figure 10. Les étapes qui figurent sur cet organigramme sont décrites plus loin.

### Tâches dynamiques

Une fois les tâches d'initialisation effectuées, le programme VPG effectue des tâches dynamiques ou des tâches de fond. Les tâches dynamiques sont par exemple l'exécution de commandes de lecture ou écriture, ou toute autre commande externe pouvant être prévue, par exemple l'exécution d'une commande d'invalidation d'une page logique.

### Exécution d'une commande d'écriture

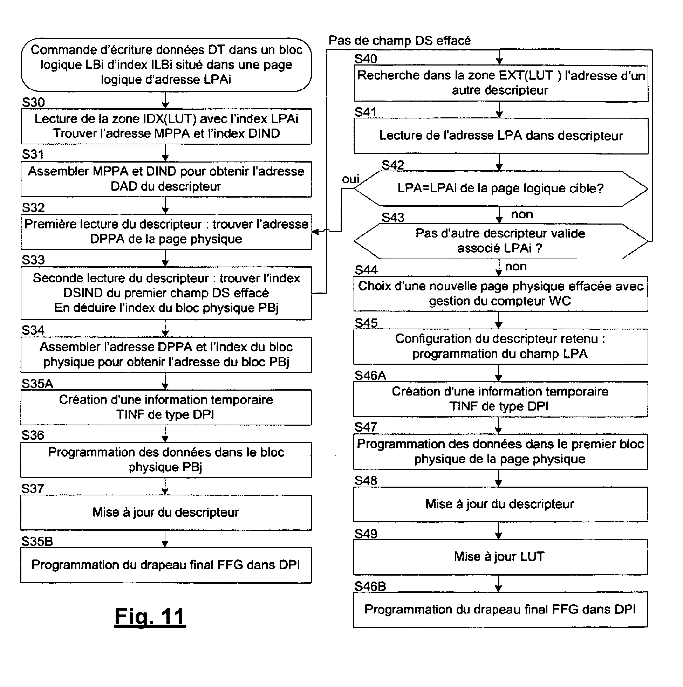

L'exécution d'une commande d'écriture a déjà été décrite à travers tout ce qui précède. La figure 11, décrite plus loin, représente un organigramme qui résume les principales étapes de l'exécution de la commande avec mise en oeuvre de tous les aspects de l'invention.

### Exécution d'une commande de lecture

L'exécution d'une commande de lecture a déjà été décrite à travers tout ce qui précède. La figure 11, décrite plus loin, représente un organigramme qui résume les principales étapes de l'exécution de la commande avec mise en oeuvre de tous les aspects de l'invention.

### Tâches de fond

Les tâches de fond s'exécutent en l'absence de commande à exécuter mais peuvent également devoir être conduites avant l'exécution d'une commande, si cela est nécessaire. Parmi les tâches de fond, on distingue les tâches suivantes :

### Effacement de pages de données invalides

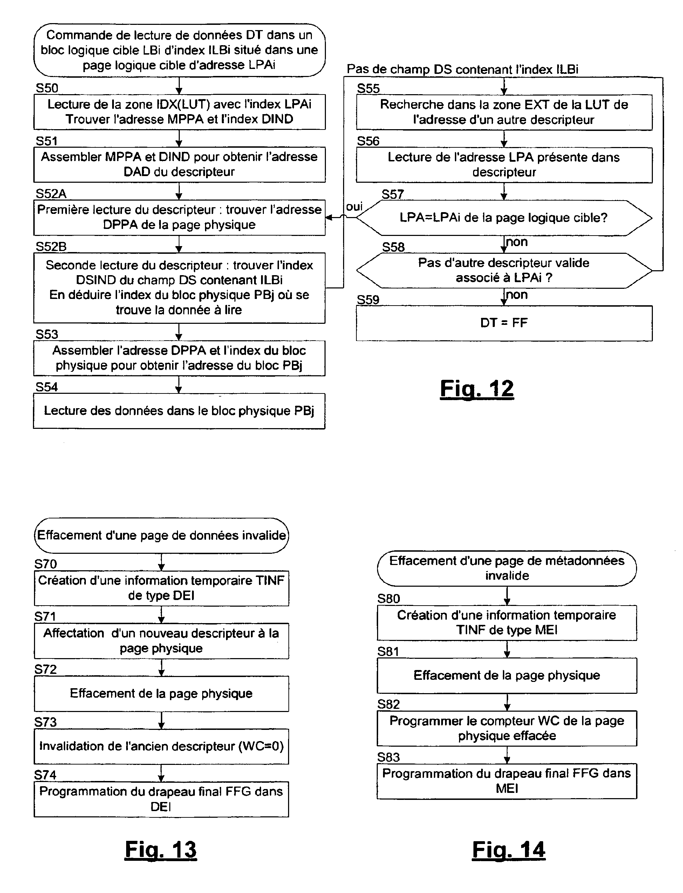

Un organigramme qui résume les principales étapes de cette tâche est représenté sur la figure 13. Les étapes qui figurent sur cet organigramme sont décrites plus loin.

### Effacement de pages de métadonnées invalides

Un organigramme qui résume les principales étapes de cette tâche est représenté sur la figure 14. Les étapes qui figurent sur cet organigramme sont décrites plus loin.

### Réarrangement de descripteurs valides

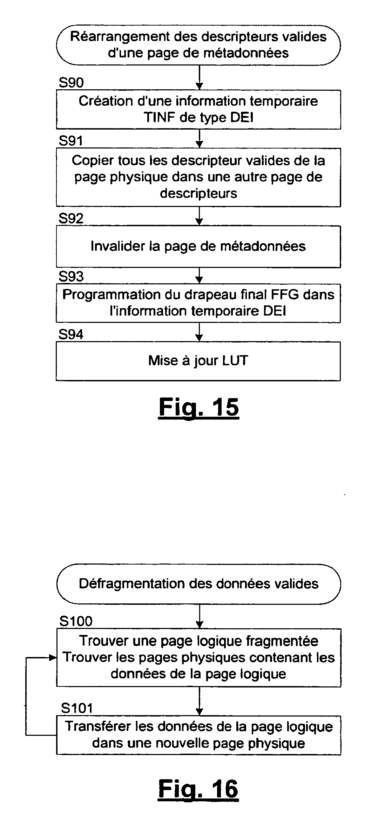

Un organigramme qui résume les principales étapes de cette tâche est représenté sur la figure 15. Les étapes qui figurent sur cet organigramme sont décrites plus loin.

### Défragmentation de données valides

Un organigramme qui résume les principales étapes de cette tâche est représenté sur la figure 16. Les étapes qui figurent sur cet organigramme sont décrites plus loin.

### Gestion statique de l'usure des pages

La tâche de gestion statique de l'usure des pages consiste à transférer des données ou des métadonnées dans des pages de données ou de métadonnées effacées ayant un compteur WC de plus forte valeur.

### Tâches esclaves

Les tâches dites "esclaves" sont celles qui sont exécutées en même temps que des tâches dynamiques ou de fond. Il s'agit notamment de la programmation des structures d'information temporaire pour la mise en oeuvre de l'algorithme anti-arrachement, et de la mise à jour de la table de correspondance LUT.

La programmation des structures d'information temporaire, déjà décrite plus haut, est effectué en relation avec toute tâche ou exécution de commande pour laquelle une structure d'information temporaire est prévue, soit ici la programmation d'un bloc physique de données (structure d'information temporaire DPI), l'effacement d'une page physique de données (structure d'information temporaire DEI), l'effacement d'une page de métadonnées (structure d'information temporaire MEI) et le réarrangement de descripteurs (structure d'information temporaire DPRI).

La gestion dynamique de l'usure a été décrite plus haut en relation avec la description du compteur WC et peut être facilitée par l'utilisation de la table de correspondance LUT (zone FRE de la table) en ce qui concerne les pages de données. En ce qui concerne les pages de métadonnées, le programme VPG effectue cette tâche à la volée au moment du choix d'une page de métadonnées effacée, en lisant les compteurs WC présents dans les champs d'en-tête de ces pages, et en sélectionnant la page présentant le compteur WC de plus faible valeur..

### Description des organigrammes

### Figure 10

L'organigramme de la figure 10 décrit des exemples de tâches d'initialisation après mise sous tension :

Au cours d'une étape S60 le programme VPG détermine si la mémoire est utilisée pour la première fois, par exemple en déterminant si la zone mémoire A2 comporte des métadonnées.

Si la mémoire est vierge, le programme VPG exécute une étape S61 où il programme tous les descripteurs à raison d'un descripteur par page physique :
- Tous les compteurs WC des descripteurs sont mis à 1 (000001)
- L'adresse DPPA de la page physique affectée à chaque descripteur est programmée dans le champ correspondant

Au cours d'une étape S62, le programme VPG exécute l'algorithme anti-arrachement :
- Au cours d'une étape S620, il lit les structures d'information temporaire TINF et recherche une anomalie.
- Au cours d'une étape S621, il reprogramme la structure d'information temporaire présentant une anomalie, le cas échéant, puis neutralise la structure d'information temporaire initiale présentant une anomalie, analyse les données concernées par l'opération interrompue, établit un diagnostic et replace la mémoire dans l'état dans lequel elle était avant le commencement de l'opération interrompue.

Au cours d'une étape S63 le programme VPG construit la table de correspondance LUT à partir d'une lecture des métadonnées.

### Figure 11

L'organigramme de la figure 11 décrit l'exécution d'une commande d'écriture d'une donnée DT dans un bloc logique cible LBi d'index ILBᵢ d'une page logique cible d'adresse LPAᵢ.

Au cours d'une étape S30, le programme VPG lit la zone IDX de la table de correspondance LUT en utilisant l'adresse LPAᵢ comme index, pour trouver l'adresse MPPA de la page de descripteurs liée à la page logique cible et l'index DIND du descripteur dans la page du descripteur.

Au cours d'une étape S31 le programme VPG assemble les champs MPPA et DIND pour obtenir l'adresse DAD du descripteur.

Au cours d'une étape S32, le programme VPG effectue une première lecture du descripteur pour trouver l'adresse DPPA de la page physique cible liée à la page logique cible.

Au cours d'une étape S33, le programme VPG effectue une seconde lecture du descripteur pour trouver l'index DSIND premier champ DS effacé (FF) et en déduit l'index du bloc physique cible PBj effacé utilisable pour programmer la donnée.

Au cours d'une étape S34, le programme VPG assemble l'adresse DPPA et l'index du bloc physique pour obtenir l'adresse du bloc physique PBj.

Au cours d'une étape S35A, le programme VPG crée une structure d'information temporaire TINF de type DPI, et programme les champs suivants : une partie du drapeau SFG, le champ TYPE, le champ DAD (adresse du descripteur), l'index DSIND du champ DS et la valeur du champ DS, puis le reste du drapeau SFG.

Au cours d'une étape S36, le programme VPG programme des données dans le bloc physique PBj.

Au cours d'une étape S37, le programme VPG met à jour le descripteur en programmant dans le champ DS effacé l'index ILBᵢ du bloc logique cible LBi.

Au cours d'une étape S35B, le programme VPG programme le drapeau final FFG dans la structure d'information temporaire DPI.

Après l'étape S33, le programme VPG va à une étape S40 au lieu d'aller à l'étape S34, s'il ne trouve pas de champ DS effacé dans le descripteur.

Au cours de l'étape S40, le programme VPG recherche dans la zone EXT de la table de correspondance LUT l'adresse d'un autre descripteur

Au cours d'une étape S41, il lit le champ d'adresse LPA présent dans le descripteur.

Au cours d'une étape S42, le programme VPG vérifie si le contenu du LPA est égal à l'adresse LPAᵢ de la page logique cible. Si la réponse est positive, le programme VPG retourne à l'étape S32 pour analyser le descripteur. Si la réponse est négative, le programme VPG va à une étape S43.

Au cours de l'étape S43, le programme VPG détermine si la table de correspondance LUT peut contenir une autre adresse de descripteur associé à la page logique cible. La réponse est négative si la recherche par approches successives décrite plus haut a déjà permis d'examiner tous les descripteurs d'adresse LPA proche de LPAi (soit LPAᵢ₋₁ et LPAᵢ₊₁) et qu'il n'existe pas d'adresse de descripteur entre les adresses des descripteurs déjà analysés. Dans ce cas, le programme VPG va à une étape S44. Si la recherche n'est pas terminée, le programme VPG retourne à l'étape S40.

Au cours de l'étape S44, le programme VPG choisit une nouvelle page physique effacée tout en appliquant l'algorithme de gestion dynamique de l'usure des pages au moyen du compteur WC, en recherchant un descripteur ayant un compteur WC de faible valeur et des champs LPA effacés. L'adresse de la page physique effacée est lue dans le champ DPPA du descripteur.

Au cours d'une étape S45, le programme VPG configure le descripteur de la page retenue en programmant le champ LPA du descripteur.

Au cours d'une étape S46A, le programme VPG crée une structure d'information temporaire TINF de type DPI, et programme les champs suivants : une partie du drapeau SFG, le champ TYPE, le champ d'adresse DAD du descripteur, l'index DSIND du champ DS et la valeur du champ DS, puis le reste du drapeau SFG.

Au cours d'une étape S47, le programme VPG programme la donnée dans le premier bloc physique de la page physique choisie.

Au cours d'une étape S48, il met à jour le descripteur en programmant dans le premier champ DS du descripteur l'index ILBᵢ du bloc logique cible LBi.

Au cours d'une étape S49, le programme VPG met à jour la table de correspondance LUT.

Au cours d'une étape S46B, il programme le drapeau final FFG dans la structure d'information temporaire DPI.

Il sera noté que l'organigramme qui vient d'être décrit ne représente pas, dans un souci de simplification du dessin, l'étape décrite plus haut de recherche d'un descripteur de même adresse LPA ayant un champ DS présentant le même index ILBᵢ que le bloc logique cible, afin d'invalider le champ DS de ce descripteur.

### Figure 12

L'organigramme de la figure 12 décrit l'exécution d'une commande de lecture d'une donnée DT dans un bloc logique cible LBi d'index ILBᵢ d'une page logique cible d'adresse LPAᵢ.

Au cours d'une étape S50, le programme VPG lit la zone IDX de la LUT en utilisant l'adresse LPAᵢ comme index, pour trouver l'adresse MPPA de la page de descripteurs liée à la page logique cible et l'index DIND du descripteur dans la page du descripteur.

Au cours d'une étape S51, le programme VPG assemble l'adresse MPPA et l'index DIND pour obtenir l'adresse DAD du descripteur.

Au cours d'une étape S52A, le programme VPG effectue une première lecture du descripteur pour trouver l'adresse DPPA de la page physique cible liée à la page logique cible.

Au cours d'une étape S52B, il effectue une seconde lecture du descripteur pour trouver l'index DSIND du champ DS contenant l'index ILBᵢ du bloc logique cible LBi, et en déduit l'index du bloc physique cible PBj où se trouve la donnée à lire. Si aucun champ DS n'est trouvé avec cet index, le programme VPG va à l'étape S55, sinon il va à l'étape S53.

Au cours de l'étape S53, le programme VPG assemble l'adresse DPPA et l'index du bloc physique pour obtenir l'adresse du bloc physique PBj.

Au cours d'une étape S54, le programme VPG lit la donnée dans le bloc physique PBj et la fournit à l'émetteur de la commande.

Au cours de l'étape S55, le programme VPG recherche dans la zone EXT de la table de correspondance LUT de l'adresse d'un autre descripteur.

Au cours d'une étape S56, il lit l'adresse LPA présente dans le descripteur.

Au cours d'une étape S57, le programme VPG vérifie si le champ LPA contient l'adresse LPAᵢ de la page logique cible. Si la réponse est positive, il va à l'étape 52A pour analyser le descripteur, sinon il va à l'étape S58.

Au cours d'une étape S58, le programme VPG détermine si la table de correspondance LUT peut contenir une autre adresse de descripteur associé à la page logique cible. La réponse est négative si la recherche par approches successives décrite plus haut a déjà permis d'examiner tous les descripteurs d'adresse LPA. Dans ce cas, le programme VPG va à une étape S59. Si la recherche n'est pas terminée, le programme VPG retourne à l'étape S55.

Au cours d'une étape S59, le programme VPG conclut que le bloc logique n'a jamais été programmé, et renvoie à l'émetteur de la commande une donnée

DT = FF ou une réponse prévue dans le protocole de communication avec l'émetteur de la commande.

### Figure 13

L'organigramme de la figure 13 décrit une opération d'effacement d'une page de données invalides.

Au cours d'une étape S70, le programme VPG crée une structure d'information temporaire TINF de type DEI et programme les champs suivants : une partie du drapeau SFG, le champ TYPE, le champ d'adresse DPPA de la page physique à effacer, le champ ODAD contenant l'adresse du descripteur de la page physique à effacer, puis le reste du drapeau SFG.

Au cours d'une étape S71, le programme VPG affecte un nouveau descripteur à la page physique dans une page de métadonnées, programme le champ DPPA et programme une valeur incrémentée du compteur WC (WC = WC+1) du descripteur initial.

Au cours d'une étape S72, il efface la page physique.

Au cours d'une étape S73, il invalide l'ancien descripteur en mettant son champ WC à 0.

Au cours d'une étape S74, le programme VPG programme le drapeau final FFG dans la structure d'information temporaire DEI.

### Figure 14

L'organigramme de la figure 14 décrit une opération d'effacement d'une page de métadonnées invalide.

Au cours d'une étape S80, le programme VPG crée une structure d'information temporaire TINF de type MEI et programme les champs suivants : une partie du drapeau SFG, le champ TYPE, l'adresse MPPA de la page physique à effacer, le champ WC, la valeur du compteur WC de la page (en-tête), puis le reste du drapeau SFG.

Au cours d'une étape S81, le programme VPG efface la page physique.

Au cours d'une étape S82, le programme VPG programme le compteur WC de la page physique effacée à partir de la valeur mémorisée dans la structure d'information temporaire.

Au cours d'une étape S83, le programme VPG programme le drapeau final FFG dans la structure d'information temporaire MEI.

### Figure 15

L'organigramme de la figure 15 décrit une opération de réarrangement des descripteurs valides d'une page de métadonnées.

Au cours d'une étape S90, le programme VPG crée une structure d'information temporaire TINF de type DEI et programme les champs suivants : une partie du drapeau SFG, le champ TYPE, le champ d'adresse MPPA de la page physique contenant les descripteurs valides à déplacer, puis le reste du drapeau SFG.

Au cours d'une étape S91, le programme VPG copie tous les descripteurs valides de la page physique dans les descripteurs vierges (DPPA=FF) d'une autre page de descripteurs ne contenant que des descripteurs valides ou le moins possible de descripteurs invalides.

Au cours d'une étape S92, le programme VPG invalide la page de métadonnées en programmant à 0 le drapeau SFG, puis en programmant à 0 le champ MID, et enfin en programmant à 0 le drapeau FFG.

Au cours d'une étape S93, le programme VPG programme le drapeau final FFG dans la structure d'information temporaire DEI.

Au cours d'une étape S94, le programme VPG met à jour la table de correspondance LUT.

### Figure 16

L'organigramme de la figure 16 décrit une opération de défragmentation de données valides.

Au cours d'une étape S100, le programme VPG cherche une page logique fragmentée, en recherchant au moyen des descripteurs les pages physiques liées à cette page et contenant des données valides. Une page logique est fragmentée si les données qu'elle contient sont dispersées dans plusieurs pages physiques.

Au cours d'une étape S101, le programme VPG génère des commandes internes d'écriture, dans une nouvelle page effacée, des données de la page logique qui sont présentes dans des blocs physiques dispersés. Puis il invalide les blocs physiques de départ. L'opération inclut la gestion dynamique de l'usure (sélection d'une page effacée ayant le plus faible compteur WC) et est sécurisée au moyen des structures d'information temporaire. Les descripteurs de la nouvelle page sont mis à jour, ainsi que les descripteurs des pages initiales. La table de correspondance LUT est également mise à jour.

On a décrit dans ce qui précède divers aspects de la présente invention, à savoir :
- la prévision d'une zone mémoire dédiée au stockage de métadonnées qui permettent de faire le lien entre des blocs logiques et des blocs physiques et permettant également de gérer une information sur le statut, valide ou invalide, des données dans les blocs physiques ;
- la prévision de structures de métadonnées compactes de type descripteurs de pages ;
- la prévision de compteurs d'usure WC associés aux pages de la mémoire, pour mettre en oeuvre un procédé de gestion dynamique de l'usure des pages et optionnellement un procédé de gestion statique de l'usure ;
- la prévision d'une zone mémoire dédiée au stockage de métadonnées formant des compteurs d'usure WC ;
- la prévision d'une zone mémoire dédiée au stockage de métadonnées structurées en informations temporaires permettant d'assurer un suivi de processus et de mettre en oeuvre un algorithme anti-arrachement lors de la mise sous tension de la mémoire ;
- la prévision d'une table de correspondance pointant vers des adresses de métadonnées au lieu de pointer vers des adresses de données, et permettant accessoirement de faciliter la gestion de l'usure des pages et l'effacement de pages invalides.

Il apparaitra clairement à l'homme de l'art que chacun de ces aspects peut être mis en oeuvre seul ou en combinaison avec les autres aspects ou une partie seulement des autres aspects de l'invention. Par exemple, des structures d'information temporaire pourraient être prévues dans une mémoire sans écriture à effacement différé, ne nécessitant pas de métadonnées de type descripteur. Également, des compteurs d'usure pourraient être prévus sans utiliser des métadonnées de type descripteur ou de type "information temporaire". La table de correspondance LUT pourrait aussi être utilisée en relation avec des structures de métadonnées différentes de celles qui ont été proposées dans ce qui précède à titre d'exemple de réalisation.

La présente invention est également susceptible de diverses applications. Bien qu'initialement conçue pour optimiser l'utilisation des mémoires FLASH, le procédé selon l'invention est susceptible d'être appliqué à tout type de mémoire dans laquelle des données doivent être effacées avant d'être programmées, par exemple des mémoires EEPROM. Notamment, l'aspect de l'invention se rapportant à l'utilisation de métadonnées de type descripteur est avantageusement appliqué à une mémoire FLASH en faisant en sorte qu'une "page physique" et qu'une "page logique" au sens du procédé correspondent à une page matérielle effaçable de la mémoire FLASH. Dans d'autres applications, une "page physique" au sens du procédé de l'invention pourrait ne pas correspondre à la plus petite partie effaçable de la mémoire utilisée. Par exemple, dans une mémoire effaçable par demi-page, une page physique au sens du procédé pourrait inclure deux-demi pages et ainsi correspondre à une page matérielle de la mémoire. Dans une mémoire effaçable par bloc, avec N blocs par page, une "page physique" au sens du procédé pourrait inclure M blocs effaçables et pourrait correspondre ou ne pas correspondre à une page matérielle de la mémoire, selon que M et N sont égaux ou non.

## Revendications

1. Procédé pour écrire et lire des données dans des cellules mémoire non volatiles effaçables et programmables électriquement, comprenant les étapes consistant à :
- prévoir une première zone mémoire (A1) non volatile (DPP),
- programmer dans des blocs effacés de la première zone mémoire des données (DT) ayant chacune une adresse logique (LPA, LBA) définie en relation avec une mémoire virtuelle,
- prévoir une seconde zone mémoire non volatile (A2),
- programmer dans la seconde zone mémoire des structures de métadonnées (DSC) associées aux données présentes dans la première zone mémoire, et comprenant, pour chaque donnée :
- l'adresse (DPPA, DS) de la donnée dans la première zone mémoire,
- l'adresse logique (LPA, DS) de la donnée, et
- une information sur le statut, valide ou invalide, de la donnée, **caractérisé en ce qu'**il comprend les étapes consistant à :
- configurer, dans une zone mémoire volatile (VM), une table de correspondance (LUT, IDX, EXT) comprenant, pour chaque adresse logique d'une donnée enregistrée dans la première zone mémoire, des adresses de structures de métadonnées (DSC) comprenant cette adresse logique, et
- lire la table de correspondance (IDX) puis lire des structures de métadonnées que la table de correspondance désigne pour retrouver, à partir de l'adresse logique d'une donnée, l'adresse dans la première zone mémoire d'un bloc contenant une donnée valide ayant cette adresse logique.

2. Procédé selon la revendication 1, comprenant, en réponse à une commande de lecture d'une donnée mentionnant l'adresse logique de la donnée, les étapes consistant à :
- rechercher dans la table de correspondance (LUT, IDX, EXT) des adresses de structures de métadonnées (DSC) dans lesquelles figure cette adresse logique,
- lire ces structures de métadonnées, et rechercher des structures de métadonnées associées à une donnée valide,
- lire dans des structures de métadonnées associées à la donnée valide, l'adresse de la donnée valide dans la première zone mémoire, et
- lire la donnée valide dans la première zone mémoire.

3. Procédé selon l'une des revendications 1 ou 2, comprenant une étape de construction de la table de correspondance de manière à ce que celle-ci comprenne :
- une première zone indexée (IDX) sur des adresses logiques, dans laquelle à une adresse logique (LPA) est associée une adresse d'une première structure de métadonnées contenant cette adresse logique, et
- une seconde zone non indexée (EXT) comprenant des adresses de secondes structures de métadonnées comprenant des adresses logiques.

4. Procédé selon la revendication 3, dans lequel les adresses logiques d'indexation de la première zone (IDX) de la table de correspondance sont des adresses (LPA) de pages logiques (LP) de la mémoire virtuelle contenant plusieurs données.

5. Procédé selon l'une des revendications 1 à 4, dans lequel :
- l'adresse d'une donnée dans la première zone mémoire (A1) est enregistrée dans les structures de métadonnées (DSC) sous la forme d'un premier index (DPPA) indiquant la position d'une page dans la première zone mémoire et d'un second index (DS) indiquant la position d'un bloc dans la page,
- l'adresse logique (LPA, LB) d'une donnée est enregistrée dans les structures de métadonnées sous la forme d'un premier index (LPA) indiquant la position d'une page logique (LP) dans la mémoire virtuelle et d'un second index (DS) indiquant la position d'un bloc logique (LB) dans la page logique, et
- une adresse de structure de métadonnées est enregistrée dans la table de correspondance sous la forme d'un index (MPPA) indiquant la position d'une page de métadonnées dans la seconde zone mémoire (A2) et d'un index (DIND) indiquant l'emplacement de la structure de métadonnées dans la page de métadonnées.

6. Procédé selon l'une des revendications 3 ou 4, comprenant, en réponse à une commande de lecture d'une donnée incluant une adresse logique (LPA), les étapes consistant à :
- au moyen de l'adresse logique (LPA), rechercher dans la première zone (IDX) de la table de correspondance une adresse d'une première structure de métadonnées dans laquelle figure cette adresse logique,
- lire la première structure de métadonnées,
- si la première structure de métadonnées se rapporte à une donnée valide, lire dans la structure de métadonnées l'adresse de la donnée valide dans la première zone mémoire, et lire la donnée dans la première zone mémoire, et
- si la première structure de métadonnées se rapporte à une donnée invalide, lire dans la seconde zone (EXT) de la table de correspondance des adresses de secondes structures de métadonnées et lire les secondes structures de métadonnées jusqu'à trouver une structure de métadonnées comprenant cette adresse logique et associée à une donnée valide, puis lire dans cette structure de métadonnées l'adresse de la donnée valide dans la première zone mémoire, et lire la donnée dans la première zone mémoire.

7. Procédé selon la revendication 6, comprenant une étape consistant à configurer la table de correspondance de manière à ce que la seconde zone (EXT) comprenne des adresses (MPPA) de structures de métadonnées classées selon un ordre croissant ou décroissant d'adresses logiques (LPA) contenues dans les structures de métadonnées que ces adresses désignent, et dans lequel l'étape de lecture de la seconde zone de la table de correspondance est conduite en appliquant une méthode convergente par approches successives basée sur le classement des adresses des structures de métadonnées, jusqu'à trouver l'adresse d'une structure de métadonnées comportant l'adresse logique, si une telle structure de métadonnées existe dans la seconde zone mémoire.

8. Procédé selon l'une des revendications 1 à 7, comprenant une étape consistant à :
- après programmation d'une donnée dans la première zone mémoire, mettre à jour une structure de métadonnées de manière à ce que l'adresse logique de la donnée venant d'être écrite figure dans la structure de métadonnées mise à jour, puis
- mettre à jour la table de correspondance de manière à ce que l'adresse de la structure de métadonnées mise à jour figure dans la table de correspondance.

9. Procédé selon l'une des revendications 1 à 8, comprenant une étape consistant à configurer les structures de métadonnées de la seconde zone mémoire sous forme de descripteurs (DSC) de pages, chaque descripteur étant associé à une page de la première zone mémoire.

10. Procédé selon la revendication 9, comprenant une étape consistant à prévoir dans un descripteur :
- un premier champ contenant l'adresse (DPPA) de la page dans la première zone mémoire ou un index de la page,
- un second champ contenant une adresse (LPA) de page logique ou un index de page logique, et
- pour chaque bloc de la page de la première zone mémoire à laquelle le descripteur est associé, un troisième champ (DS) contenant une information sur l'emplacement du bloc dans la page, une information sur le statut du bloc parmi au moins les trois statuts suivants : bloc effacé, bloc contenant une donnée valide ou bloc contenant un donnée invalide, et une information sur la position dans la page logique de la donnée enregistrée dans le bloc considéré.

11. Procédé selon la revendication 10, dans lequel le troisième champ (DS) est un champ indexé dont la position dans le descripteur désigne un bloc de la page de la première zone mémoire à laquelle le descripteur est associé, et dont le contenu peut présenter une valeur effacée indiquant que le bloc désigné est effacé, une valeur programmée indiquant que le bloc désigné contient une donnée invalide, ou une valeur partiellement programmée donnant une information sur l'emplacement dans la page logique de la donnée enregistrée dans le bloc.

12. Procédé selon l'une des revendications 9 à 11, comprenant une étape consistant à programmer dans chaque descripteur (DSC) un compteur d'usure (WC) de la page à laquelle le descripteur est associé, et une étape consistant à incrémenter le compteur d'usure après chaque effacement de la page.

13. Procédé selon l'une des revendications 9 à 12, comprenant une étape consistant à prévoir dans la table de correspondance une troisième zone (FRE) comprenant des adresses de descripteurs associés à des pages effacées de la première zone mémoire.

14. Procédé selon les revendications 12 et 13, comprenant une étape consistant à classer les adresses de descripteurs dans la troisième zone (EXT) de la table de correspondance par ordre croissant ou décroissant des valeurs des compteurs d'usure (WC) contenus dans les descripteurs que ces adresses désignent.

15. Procédé selon l'une des revendications 9 à 14, comprenant une étape consistant à prévoir dans la table de correspondance une zone (INV) comprenant des adresses de descripteurs associés à des pages ne contenant que des données invalides.

16. Procédé selon l'une des revendications 1 à 15, comprenant une étape consistant à effacer des pages de la première zone mémoire ne contenant que des données invalides et effacer des pages de la seconde zone mémoire ne contenant que des structures de métadonnées invalides.

17. Procédé selon l'une des revendications 1 à 16, comprenant une étape consistant à agencer les première et seconde zones mémoire (A1, A2) au sein d'une même mémoire non volatile (NVM).

18. Circuit intégré (ICC) comprenant une unité de traitement (PU), au moins une mémoire non volatile (NVM) comprenant des cellules mémoire effaçables et programmables électriquement et une zone mémoire volatile (VM), **caractérisé en ce que** l'unité de traitement est configurée pour recevoir des commande d'écriture (WR) et de lecture (RD) et exécuter les commandes conformément au procédé selon l'une des revendications 1 à 17.

19. Objet portatif (HD) comprenant un circuit intégré selon la revendication 18.

## Patentansprüche

1. Verfahren zum Schreiben und Lesen von Daten in nicht-flüchtigen elektrisch löschbaren und programmierbaren Speicherzellen, umfassend die Schritte, die darin bestehen:
- eine erste nicht-flüchtige (DPP) Speicherzone (A1) vorzusehen,
- in gelöschten Blöcken der ersten Speicherzone Daten (DT) zu programmieren, die jeweils eine logische in Verbindung mit einem virtuellen Speicher definierte Adresse (LPA, LBA) haben,
- eine zweite nicht-flüchtige Speicherzone (A2) vorzusehen,
- in der zweiten Speicherzone Metadatenstrukturen (DSC) zu programmieren, die mit den in der ersten Speicherzone anwesenden Daten assoziiert sind, und die für jedes Datum Folgendes umfassen:
- die Adresse (DPPA, DS) des Datums in der ersten Speicherzone,
- die logische Adresse (LPA, DS) des Datums, und
- eine Information über den Status, entweder gültig oder ungültig, des Datums,
- in einer flüchtigen Speicherzone (VM) eine Korrespondenztabelle (LUT, IDX, EXT) zu konfigurieren, die für jede logische Adresse eines in der ersten Speicherzone registrierten Datums, Adressen von diese logische Adresse umfassenden Metadatenstrukturen (DSC) umfasst, und
- die Korrespondenztabelle (IDX) zu lesen, dann von der Korrespondenztabelle bezeichnete Metadatenstrukturen zu lesen, um aus der logischen Adresse eines Datums die Adresse in der ersten Speicherzone eines Blockes wiederzufinden, der ein diese logische Adresse aufweisendes gültiges Datum enthält.

2. Verfahren nach Anspruch 1, umfassend, in Antwort auf einen Lesebefehl zum Lesen eines Datums, das die logische Adresse des Datums nennt, die Schritte, die darin bestehen:
- in der Korrespondenztabelle (LUT, IDX, EXT) Metadatenstrukturadressen (DSC) zu suchen, unter denen diese logische Adresse vorkommt,
- diese Metadatenstrukturen zu lesen, und mit einem gültigen Datum assoziierte Metadatenstrukturen zu suchen,
- in mit dem gültigen Datum assoziierten Metadatenstrukturen die Adresse des gültigen Datums in der ersten Speicherzone zu lesen, und
- das gültige Datum in der ersten Speicherzone zu lesen.

3. Verfahren nach einem der Ansprüche 1 oder 2, umfassend einen Schritt der Konstruktion der Korrespondenztabelle damit diese Folgendes umfasst:
- eine erste auf logische Adressen indexierte Zone (IDX), in der eine Adresse einer ersten eine logische Adresse (LPA) enthaltenden Metadatenstruktur mit dieser logischen Adresse assoziiert ist, und
- eine zweite nicht-indexierte Zone (EXT), die Adressen von zweiten Metadatenstrukturen, die logische Adressen aufweisen, umfasst.

4. Verfahren nach Anspruch 3, bei dem die logischen Adressen zur Indexierung der ersten Zone (IDX) der Korrespondenztabelle Adressen (LPA) von mehrere Daten enthaltenden logischen Seiten (LP) des virtuellen Speichers sind.

5. Verfahren nach einem der Ansprüche 1 bis 4, bei dem:
- die Adresse eines Datums in der ersten Speicherzone (A1) in den Metadatenstrukturen (DSC) in der Form eines ersten die Position einer Seite in der ersten Speicherzone anzeigenden Index (DPPA) und eines zweiten die Position eines Blockes in der Seite anzeigenden Index (DS) registriert wird,
- die logische Adresse (LPA, LB) eines Datums in den Metadatenstrukturen in der Form eines ersten die Position einer logischen Seite (LP) im virtuellen Speicher anzeigenden Index (LPA) und eines zweiten die Position eines logischen Blockes (LB) in der logischen Seite anzeigenden Index (DS) registriert wird, und
- eine Metadatenstrukturadresse in der Korrespondenztabelle in der Form eines die Position einer Metadatenseite in der zweiten Speicherzone (A2) anzeigenden Index (MPPA) und eines den Platz der Metadatenstruktur in der Metadatenseite anzeigenden Index (DIND) registriert wird.

6. Verfahren nach einem der Ansprüche 3 oder 4, umfassend, in Antwort auf einen Lesebefehl zum Lesen eines eine logische Adresse (LPA) enthaltenden Datums, die Schritte, die darin bestehen:
- anhand der logischen Adresse (LPA) in der ersten Zone (IDX) der Korrespondenztabelle eine Adresse einer ersten diese logische Adresse enthaltenden Metadatenstruktur zu suchen,
- die erste Metadatenstruktur zu lesen,
- wenn die erste Metadatenstruktur sich auf ein gültiges Datum bezieht, in der Metadatenstruktur die Adresse des gültigen Datums in der ersten Speicherzone zu lesen, und das Datum in der ersten Speicherzone zu lesen, und
- wenn die erste Metadatenstruktur sich auf ein ungültiges Datum bezieht, in der zweiten Zone (EXT) der Korrespondenztabelle Adressen von zweiten Metadatenstrukturen zu lesen, und die zweiten Metadatenstrukturen zu lesen, bis eine diese logische Adresse umfassende und mit einem gültigen Datum assoziierte Metadatenstruktur gefunden wird, dann in dieser Metadatenstruktur die Adresse des gültigen Datums in der ersten Speicherzone zu lesen, und das Datum in der ersten Speicherzone zu lesen.

7. Verfahren nach Anspruch 6, umfassend einen Schritt, der darin besteht, die Korrespondenztabelle so zu konfigurieren, dass die zweite Zone (EXT) Adressen (MPPA) von Metadatenstrukturen umfasst, die in aufsteigender oder absteigender Ordnung logischer Adressen (LPA) angeordnet sind, die in den von diesen Adressen bezeichneten Metadatenstrukturen enthalten sind, und bei dem der Schritt des Lesens der zweiten Zone der Korrespondenztabelle ausgeführt wird, indem eine Konvergenzmethode durch schrittweise Annäherungen basierend auf der Anordnung der Metadatenstrukturadressen angewendet wird, bis die Adresse einer die logische Adresse aufweisende Metadatenstruktur gefunden wird, wenn eine solche Metadatenstruktur in der zweiten Speicherzone existiert.

8. Verfahren nach einem der Ansprüche 1 bis 7, umfassend einen Schritt, der darin besteht:
- nachdem ein Datum in der ersten Speicherzone programmiert wird, eine Metadatenstruktur so zu aktualisieren, dass die logische Adresse des soeben geschriebenen Datums in der aktualisierten Metadatenstruktur vorkommt, dann
- die Korrespondenztabelle so zu aktualisieren, dass die Adresse der aktualisierten Metadatenstruktur in der Korrespondenztabelle vorkommt.

9. Verfahren nach einem der Ansprüche 1 bis 8, umfassend einen Schritt, der darin besteht, die Metadatenstrukturen der zweiten Speicherzone in Form von Seitendeskriptoren (DSC) zu konfigurieren, wobei jeder Deskriptor mit einer Seite der ersten Speicherzone assoziiert ist.

10. Verfahren nach Anspruch 9, umfassend einen Schritt, der darin besteht, in einem Deskriptor Folgendes vorzusehen:
- ein erstes Feld, das die Adresse (DPPA) der Seite in der ersten Speicherzone oder einen Index der Seite enthält,
- ein zweites Feld, das eine Adresse (LPA) einer logischen Seite oder einen Index einer logischen Seite enthält, und
- für jeden Block der Seite der ersten Speicherzone, mit der der Deskriptor assoziiert ist, ein drittes Feld (DS) enthaltend eine Information über den Platz des Blockes in der Seite, eine Information über den Status des Blockes aus wenigstens den drei folgenden Status: Block gelöscht, Block mit einem gültigen Datum oder Block mit einem ungültigen Datum, und eine Information über die Position in der logischen Seite des im betroffenen Block registrierten Datums.

11. Verfahren nach Anspruch 10, bei dem das dritte Feld (DS) ein indexiertes Feld ist, dessen Position im Deskriptor einen Block der Seite der ersten Speicherzone, mit der der Deskriptor assoziiert ist, bezeichnet, und dessen Inhalt Folgendes aufweisen kann: einen gelöschten Wert, der anzeigt, dass der bezeichnete Block gelöscht ist, einen programmierten Wert, der anzeigt, dass der bezeichnete Block ein ungültiges Datum enthält, oder einen teilweise programmierten Wert, der eine Information über den Platz in der logischen Seite des im Block registrierten Datums liefert.

12. Verfahren nach einem der Ansprüche 9 bis 11, umfassend einen Schritt, der darin besteht, in jedem Deskriptor (DSC) einen Verschleißzähler (WC) der Seite zu programmieren, mit der der Deskriptor assoziiert ist, und einen Schritt, der darin besteht, den Verschleißzähler nach jedem Löschen der Seite zu inkrementieren.

13. Verfahren nach einem der Ansprüche 9 bis 12, umfassend einen Schritt, der darin besteht, in der Korrespondenztabelle eine dritte Zone (FRE) vorzusehen, die Adressen von mit gelöschten Seiten der ersten Speicherzone assoziierten Deskriptoren umfasst.

14. Verfahren nach den Ansprüchen 12 und 13, umfassend einen Schritt, der darin besteht, die Deskriptorenadressen in der dritten Zone (EXT) der Korrespondenztabelle in aufsteigender oder absteigender Ordnung der Werte der Verschleißzähler (WC) anzuordnen, die in den von diesen Adressen bezeichneten Deskriptoren enthalten sind.

15. Verfahren nach einem der Ansprüche 9 bis 14, umfassend einen Schritt, der darin besteht, in der Korrespondenztabelle eine Zone (INV) vorzusehen, die Adressen von Deskriptoren umfasst, die mit nur ungültige Daten enthaltenden Seiten assoziiert sind.

16. Verfahren nach einem der Ansprüche 1 bis 15, umfassend einen Schritt, der darin besteht, nur ungültige Daten enthaltende Seiten der ersten Speicherzone zu löschen, und nur ungültige Metadatenstrukturen enthaltende Seiten der zweiten Speicherzone zu löschen.

17. Verfahren nach einem der Ansprüche 1 bis 16, umfassend einen Schritt, der darin besteht, die erste und die zweite Speicherzone (A1, A2) innerhalb eines selben nicht-flüchtigen Speichers (NVM) anzuordnen.

18. Integrierte Schaltung (ICC) umfassend eine Verarbeitungseinheit (PU), wenigstens einen nicht-flüchtigen Speicher (NVM), der elektrisch löschbare und programmierbare Speicherzellen umfasst, und eine nicht-flüchtige Speicherzone (VM), **dadurch gekennzeichnet, dass** die Verarbeitungseinheit dafür konfiguriert ist, Schreibe- (WR) und Lesebefehle (RD) zu empfangen und die Befehle gemäß dem Verfahren nach einem der Ansprüche 1 bis 17 auszuführen.

19. Tragbares Objekt (HD) umfassend eine integrierte Schaltung nach Anspruch 18.

## Claims

1. Method for writing and reading data in electrically erasable and programmable nonvolatile memory cells, comprising the steps consisting of:
- providing a first nonvolatile (DPP) memory zone (A1),
- writing, in erased blocks of the first memory zone, data (DT) each having a logical address (LPA, LBA) defined in relation with a virtual memory,
- providing a second nonvolatile memory zone (A2),
- writing, in the second memory zone, metadata structures (DSC) associated with the data present in the first memory zone, and comprising, for each data:
- the address (DPPA, DS) of the data in the first memory zone,
- the logical address (LPA, DS) of the data, and
- an information on the status, valid or invalid, of the data comprising the steps consisting of:
- configuring, in a volatile memory zone (VM), a look-up table (LUT, IDX, EXT) comprising, for each logical address of a data stored in the first memory zone, addresses of metadata structures (DSC) comprising this logical address, and
- reading the look-up table (IDX), then reading the metadata structures that the look-up table designates so as to find, from the logical address of a data, the address in the first memory zone of a block containing a valid data having this logical address.

2. Method according to claim 1, comprising, in response to a read command of a data mentioning the logical address of the data, the steps consisting of:
- searching in the look-up table (LUT, IDX, EXT) for addresses of metadata structures (DSC) in which this logical address appears,
- reading these metadata structures, and searching for metadata structures associated with a valid data,
- reading in the metadata structures associated with the valid data, the address of the valid data in the first memory zone, and
- reading the valid data in the first memory zone.

3. Method according to one of claims 1 or 2, comprising a step of constructing the look-up table in a manner such that it comprises:
- a first indexed zone (IDX) of the logical addresses, in which a logical address (LPA) is associated with an address of a first metadata structure containing this logical address, and
- a second non-indexed zone (EXT) comprising addresses of second metadata structures comprising logical addresses.

4. Method according to claim 3, wherein the logical addresses of indexation of the first zone (IDX) of the look-up table are addresses (LPA) of logical pages (LP) of the virtual memory containing several data.

5. Method according to one of claims 1 to 4, wherein:
- the address of a data in the first memory zone (A1) is stored in the metadata structures (DSC) in the form of a first index (DPPA) indicating the position of a page in the first memory zone and of a second index (DS) indicating the position of a block in the page,
- the logical address (LPA, LB) of a data is stored in the metadata structures in the form of a first index (LPA) indicating the position of a logical page (LP) in the virtual memory and of a second index (DS) indicating the position of a logical block (LB) in the logical page, and
- a metadata structure address is stored in the look-up table in the form of an index (MPPA) indicating the position of a metadata page in the second memory zone (A2) and of an index (DIND) indicating the location of the metadata structure in the metadata page.

6. Method according to one of claims 3 or 4, comprising, in response to a read command of a data including a logical address (LPA), the steps consisting of:
- by means of the logical address (LPA), searching in the first zone (IDX) of the look-up table for an address of a first metadata structure in which this logical address appears,
- reading the first metadata structure,
- if the first metadata structure relates to a valid data, reading in the metadata structure the address of the valid data in the first memory zone, and reading the data in the first memory zone, and
- if the first metadata structure relates to an invalid data, reading in the second zone (EXT) of the look-up table the addresses of second metadata structures and reading the second metadata structures until a metadata structure comprising this logical address and associated with a valid data is found; then reading in this metadata structure the address of the valid data in the first memory zone, and reading the data in the first memory zone.

7. Method according to claim 6, comprising a step consisting of configuring the look-up table in a manner such that the second zone (EXT) comprises addresses (MPPA) of metadata structures classed according to an increasing or decreasing order of the logical addresses (LPA) contained in the metadata structures that these addresses designate, and in which the step of reading of the second zone of the look-up table is done by applying a convergent method by successive approaches based on the classification of the addresses of the metadata structures, until the address of a metadata structure comprising the logical address is found, if such a metadata structure exists in the second memory zone.

8. Method according to one of claims 1 to 7, comprising a step consisting of:
- after the writing of a data in the first memory zone, updating a metadata structure such that the logical address of the data that was just written appears in the updated metadata structure, then
- updating the look-up table such that the address of the metadata structure appears in the look-up table.

9. Method according to one of claims 1 to 8, comprising a step consisting of configuring the metadata structures of the second memory zone in the form of page descriptors (DSC), each descriptor being associated with a page of the first memory zone.

10. Method according to claim 9, comprising a step consisting of providing in a descriptor:
- a first field containing the address (DPPA) of the page in the first memory zone or a page index,
- a second field comprising a logical page address (LPA) or a logical page index, and
- for each block of the page of the first memory zone with which the descriptor is associated, a third field (DS) containing an information about the location of the block in the page; an information about the status of the block from among the at least three following statuses: block erased, block containing a valid data, or block containing an invalid data; and an information about the position in the logical page of the data stored in the considered block.

11. Method according to claim 10, wherein the third field (DS) is an indexed field of which the position in the descriptor designates a block of the page of the first memory zone with which the descriptor is associated, and of which the contents may have an erased value indicating that the designated block is erased, a programmed value indicating that the designated block contains an invalid data, or a partially programmed value giving an information about the location in the logical page of the data stored in the block.

12. Method according to one of claims 9 to 11, comprising a step consisting of writing in each descriptor (DSC) a wear counter (WC) of the page with which the descriptor is associated, and a step consisting of incrementing the wear counter after each erasure of the page.

13. Method according to one of claims 9 to 12, comprising a step consisting of providing in the look-up table a third zone (FRE) comprising descriptor addresses associated with erased pages of the first memory zone.

14. Method according to claims 12 and 13, comprising a step consisting of classing the descriptor addresses in the third zone (EXT) of the look-up table by increasing or decreasing order of the wear counter (WC) values contained in the descriptors that these addresses designate.

15. Method according to one of claims 9 to 14, comprising a step consisting of providing in the look-up table a zone (INV) comprising descriptor addresses associated with pages only containing invalid data.

16. Method according to one of claims 1 to 15, comprising a step consisting of erasing pages of the first memory zone only containing invalid data and erasing pages of the second memory zone only containing invalid metadata structures.

17. Method according to one of claims 1 to 16, comprising a step consisting of arranging the first and second memory zones (A1, A2) within a same nonvolatile memory (NVM).

18. Integrated circuit (ICC) comprising a processing unit (PU), at least one nonvolatile memory (NVM) comprising electrically programmable and erasable memory cells and a volatile memory zone (VM), **characterized in that** the processing unit is configured to receive write commands (WR) and read commands (RD) and to execute the commands in conformance with the method according to one of claims 1 to 17.

19. Portable object (HD) comprising an integrated circuit according to claim 18.
